# EUROPÄISCHE PATENTSCHRIFT

(11) **EP 4 006 559 B1**
(45) Veröffentlichungstag und Bekanntmachung des Hinweises auf die Patenterteilung: **19.02.2025**
(21) Anmeldenummer: 21210854.2
(22) Anmeldetag: 26.11.2021
(51) Int. Cl.: F24H 15/164, F24H 15/168, F24H 15/172, F24H 15/269, G01R 19/25, H02J 3/14

(54) **VERFAHREN, SYSTEM UND COMPUTERPROGRAMM-PRODUKT ZUM ERMITTELN EINES LASTVERSCHIEBEPOTENTIALS EINES ELEKTRISCHEN VERBRAUCHERS**
METHOD, SYSTEM AND COMPUTER PROGRAM PRODUCT FOR DETERMINING A LOAD DISPLACEMENT POTENTIAL OF AN ELECTRICAL CONSUMER
PROCÉDÉ, SYSTÈME ET PRODUIT-PROGRAMME INFORMATIQUE PERMETTANT DE DÉTERMINER UN POTENTIEL DE DÉPLACEMENT DE CHARGE D'UN CONSOMMATEUR ÉLECTRIQUE

(30) Priorität: 30.11.2020 DE 102020215070
(43) Veröffentlichungstag der Anmeldung: 01.06.2022
(73) Patentinhaber: Viessmann Climate Solutions SE, 35108 Allendorf (DE)
(72) Erfinder: HAFNER, Bernd, 35108 Allendorf (DE); SCHAUB, Michael, 35260 Stadtallendorf (DE)
(74) Vertreter: MERH-IP Matias Erny Reichl Hoffmann Patentanwälte PartG mbB

(56) Entgegenhaltungen:
- DE-A1- 102009 010 117
- DE-A1- 102013 214 996
- DE-A1- 102017 217 055
- DE-A1- 102017 220 414
- STADLER M ET AL: "Modelling and evaluation of control schemes for enhancing load shift of electricity demand for cooling devices", ENVIRONMENTAL MODELLING & SOFTWARE, ELSEVIER, AMSTERDAM, NL, vol. 24, no. 2, 1 February 2009 (2009-02-01), pages 285 - 295, XP025506192, ISSN: 1364-8152, [retrieved on 20080902], DOI: 10.1016/J.ENVSOFT.2008.07.003

## Beschreibung

### Technischer Hintergrund

Im Rahmen der Energiewende wird ein stetig wachsender Teil der elektrischen Energie in einem Energieversorgungsnetz mittels Sonnenenergie, Windenergie etc. erzeugt. Im Vergleich zu herkömmlichen Kraftwerksanlagen, wie beispielsweise Atomkraftwerken und Kohlekraftwerken, unterliegen Photovoltaikanlagen und Windkraftanlagen Umwelteinflüssen wie dem Vorhandensein von Sonnenlicht bzw. dem Vorhandensein eines Windes. Dies bedeutet im Umkehrschluss, dass eine bedarfsorientierte Energieerzeugung mittels Sonnenenergie bzw. Windenergie schwierig ist.

Somit ist es ein Ziel, zumindest einen Teil des Energiebedarfs an aktuelle Energieressourcen zu koppeln.

Die EP 2 822 134 A1 zeigt dazu ein Managementgerät, das eine Vielzahl an Wärmepumpensystemen verwaltet und das eine von den Wärmepumpensystemen verbrauchte gesamte Energiemenge an einen Zielwert anpasst. Das Managementgerät umfasst dazu eine Anfrageübertragungseinheit, die Werte für einen gewünschten Energieverbrauch zu jeder der Wärmepumpensysteme überträgt, eine Informationsempfangseinheit, die von jeder der Wärmepumpen aktuelle Energieverbrauchswerte empfängt, eine Datenbank zum Speichern eines Ansprechverhaltens der Energieverbraucher jedes der Wärmepumpensysteme in Verbindung mit den Werten des gewünschten Energieverbrauchs und eine Lerneinheit, die das Ansprechverhalten lernt und Lernergebnisse reflektiert basierend auf den in der Datenbank gespeicherten Daten.

Die DE 10 2017 220 414 A1 zeigt ein Verfahren zum Betreiben eines Wärmespeichersystems, wobei eine mit dem Betrieb der Wärmepumpe verbundene elektrische Last zeitlich verschoben wird und wobei die Lastverschiebung durch das lokale Energiemanagement gesteuert wird, wobei eine Leistungsaufnahme der Wärmepumpe so gesteuert wird, dass diese Leistungsaufnahme einem von dem lokalen Energiemanagement vorgegebenen Vorgabewert für die elektrische Leistungsaufnahme vorliegt, sofern wärmeseitige Anforderungen an das Wärmespeichersystem dies zulassen.

Die DE 10 2009 010 117 A1 zeigt ein Verfahren zur Vergleichmäßigung der Bezugsleistung von elektrischer Energie bei einem Energieverbraucher, der mehrere elektrische energieverbrauchende Geräte hat, die Gruppen unterschiedlicher Priorität zugeordnet sind, wobei in einem ersten Schritt über einen definierbaren Zeitraum mit Kalenderbezug ein ungesteuerter Verbrauch an Leistung ermittelt wird und wobei in einem zweiten Schritt mit diesem ungesteuerten Verbrauch an Leistung ein Mittelwert gebildet wird, der während eines gleichartigen nachfolgenden Zeitraumes als Vorgabe für einen Sollwert benutzt wird, wobei die Geräte ihrer Priorität gemäß geschaltet werden, um mit der aktuellen Leistung den Sollwert nicht zu überfahren.

In STADLER M ET AL: "Modelling and evaluation of control schemes for enhancing load shift of electricity demand for cooling devices", ENVIRONMENTAL MODELLING & SOFTWARE, ELSEVIER, AMSTERDAM, NL, Bd. 24, Nr. 2, 1. Februar 2009, Seiten 285-295, ISSN: 1364-8152, DOI: 10.1016/J.ENVSOFT.2008.07.003 werden zwei Arten von Steuersignalen diskutiert und verglichen, um den thermischen Speicher von elektrischen Haushaltsgeräten als Regelenergie zu nutzen. Es wird ein Simulationsmodell steuerbarer Kühlgeräte hinsichtlich ihrer Fähigkeit, ihren Energiebedarf in Abhängigkeit von parametrisierten externen Signalen zu verschieben, analysiert. Es wird gezeigt, dass beide Arten von Steuersignalen für kurzfristige Reserven mit einer Lieferzeit von 15 Minuten genutzt werden können, sich aber in den möglichen Formen der resultierenden Lastkurven und in der Reaktionszeit der Regelstrecke unterscheiden. Zusätzlich zu dem Simulationsmodell wird ein Modell für das synergetische Verhalten eines Ensembles von Kühlschränken, die auf Steuersignale reagieren gezeigt. Dieses mathematische Modell prognostiziert den Strombedarf eines Ensembles von gesteuerten Geräten.

Die DE 10 2013 214 996 A1 zeigt eine Vorrichtung zur Lastverschiebung in intelligenten Stromverteilungsnetzen, bei der der Verbrauch elektrischer Energie zu einem möglichst günstigen Zeitpunkt erfolgt, also dann, wenn viel Energie im Netz ist, bzw. wenn ein variabler Strompreis gerade niedrig ist. Dies wird dadurch bewirkt, dass eine Prognose für den Verlauf des Strompreises über ein nächstes Zeitintervall in einer Vorrichtung empfangbar und daraus in einem gewissen Takt aktuelle binäre Werte für Schaltempfehlungen für eine Mehrzahl von Geräten ermittelbar sind, wobei die Schaltempfehlungen jeweils nur nach den Parametern "Schaltintervall", "An-Wahrscheinlichkeit" und "Betrachtetes Zeitfenster" klassifiziert werden.

Die DE 10 2017 217 055 A1 zeigt ein Energieflusssteuergerät zur Steuerung einer Lastverschiebung einer Mehrzahl von an einem Netzanschlusspunkt angeschlossenen Verbrauchern elektrischer Energie. Das Energieflusssteuergerät ist dazu eingerichtet, relative Effizienzen der Verbraucher miteinander zu vergleichen und individuelle Lastverschiebungen der Verbraucher in Abhängigkeit von den relativen Effizienzen zu steuern, wobei jede relative Effizienz definiert ist als eine auf eine aktuelle Effizienz des Verbrauchers normierte Effizienz des Verbrauchers, mit welcher der Verbraucher aktuell mit zur Lastverschiebung vergrößerter elektrischer Last arbeiten würde.

Ausgehend davon ist es Aufgabe der Erfindung, ein verbessertes Verfahren zum Ermitteln eines Lastverschiebepotenzials eines elektrischen Verbrauchers sowie ein entsprechendes System bereitzustellen.

### Beschreibung der Erfindung

Die Aufgabe wird mit den Merkmalen der unabhängigen Ansprüche gelöst. Die abhängigen Ansprüche beziehen sich auf besondere Ausführungsformen der Erfindung. Im Folgenden sind Beispiele gezeigt, die zum besseren Verständnis der Erfindung dienen.

Ein Aspekt der Anmeldung ist ein Verfahren zum Ermitteln eines Lastverschiebepotentials eines elektrischen Verbrauchers. Der elektrische Verbraucher kann insbesondere zur Wärmeerzeugung und/oder Kälteerzeugung in einem oder mehreren Heiz- und/oder Kühlkreisen eingerichtet sein. Der elektrische Verbraucher kann beispielsweise eine Wärmepumpe, ein elektrischer Heizkörper, ein elektrisch beheizter Warmwasserspeicher, ein Kühlaggregat etc. sein.

Ein Lastverschiebepotential kann ein Maß dafür sein, inwieweit eine Anpassung einer elektrischen Last des elektrischen Verbrauchers, insbesondere hinsichtlich eines Zeitpunktes eines Energieverbrauchs des elektrischen Verbrauchers und/oder hinsichtlich einer Energiemenge zu einem Zeitpunkt in einem Zeitbereich, möglich ist. Ein Lastverschiebepotential kann dazu eine oder mehrere Größen umfassen. Eine Anpassung (Lastverschiebung) kann dann vorteilhafterweise hinsichtlich des Zeitpunkts des Energieverbrauchs und/oder hinsichtlich der elektrischen Leistung des elektrischen Energieverbrauchs innerhalb eines vorgegebenen Zeitintervalls des elektrischen Verbrauchers gemäß dem Lastverschiebepotential erfolgen, sodass Wärmeanforderungen bzw. Kälteanforderungen an den elektrischen Verbraucher ohne bzw. mit nur geringen Einschränkungen durch den elektrischen Verbraucher erfüllt/bedient werden können.

Ein erster Schritt des Verfahrens kann das Erfassen eines elektrischen Energieverbrauchs des elektrischen Verbrauchers als Referenzenergieverbrauch des elektrischen Verbrauchers sein. Das Erfassen des elektrischen Energieverbrauchs kann beispielsweise mittels einer Einheit zum Erfassen eines elektrischen Energieverbrauchs erfolgen. Das Erfassen des elektrischen Energieverbrauchs kann ein Erfassen eines Energieverbrauchs in Abhängigkeit der Zeit, ein Erfassen einer elektrischen Leistung des elektrischen Energieverbrauchs in Abhängigkeit der Zeit etc. umfassen.

In manchen Ausführungsformen kann das Erfassen des elektrischen Energieverbrauchs ein Erfassen eines Startzeitpunkts eines Lastbetriebs des elektrischen Verbrauchers, eines Endzeitpunkts des Lastbetriebs des elektrischen Verbrauchers und der elektrischen Leistung des elektrischen Verbrauchers während des Lastbetriebs umfassen. Ein Lastbetrieb kann ein Betriebszustand des elektrischen Verbrauchers sein, mit dem Ziel, eine vorgegebene Wärme oder Kälte zu erzeugen.

Ein weiterer Schritt des Verfahrens kann das Ermitteln eines Lastverschiebepotentials des elektrischen Verbrauchers in Abhängigkeit des erfassten Referenzenergieverbrauchs des elektrischen Verbrauchers sein. Dies hat den Vorteil, dass ein Lastverschiebepotential mit niedrigem Aufwand und einer geringen Anzahl an Sensoren ermittelt werden kann. Ein weiterer Vorteil ist, dass ein aussagekräftiges Lastverschiebepotential mit einem möglichst geringen Eingriff in die Privatsphäre von Menschen ermittelt werden kann, da keine Informationen über Wohnraumtemperaturen/Temperaturen erforderlich sind. Außerdem kann dadurch ein entsprechendes Verfahren bei bestehenden elektrischen Verbrauchern besonders einfach nachgerüstet werden.

Ein besonders vorteilhaftes Verfahren kann den zusätzlichen Schritt Ermitteln einer Beladezeitkonstante des elektrischen Verbrauchers in Abhängigkeit des erfassten Referenzenergieverbrauchs umfassen, wobei das Ermitteln des Lastverschiebepotentials in Abhängigkeit der Beladezeitkonstante des elektrischen Verbrauchers erfolgt und das Ermitteln einer Beladezeitkonstante des elektrischen Verbrauchers in Abhängigkeit einer Dauer eines oder mehrerer Betriebsintervalle des elektrischen Verbrauchers erfolgt.

Ein Betriebsintervall kann ein Intervall sein, in dem der elektrische Verbraucher in einem Lastbetrieb betrieben wird. Eine Beladezeitkonstante kann beispielsweise durch bilden des Mittelwerts über die Dauer einer Vielzahl an Betriebsintervallen und/oder einer sonstigen mathematischen Funktion mit der Dauer der Vielzahl an Betriebsintervallen als Funktionsargument erfolgen.

Dies hat den Vorteil, dass eine Abschätzung möglich ist, wie lange in etwa der elektrische Verbraucher an einem Stück in Betrieb ist. Dadurch ist es möglich, den Endzeitpunkt eines Betriebsintervalls vorherzusagen und dadurch kann insbesondere eine mögliche zeitliche Verschiebung der Last (des Energieverbrauchs) abgeschätzt werden, ohne dass Wärme- bzw. Kälteanforderungen an den elektrischen Verbraucher dadurch beeinflusst werden.

Ein besonders optimiertes Verfahren kann den zusätzlichen Schritt Ermitteln einer Entladezeitkonstante des elektrischen Verbrauchers in Abhängigkeit des erfassten Referenzenergieverbrauchs umfassen, wobei das Ermitteln des Lastverschiebepotentials in Abhängigkeit der Entladezeitkonstante des elektrischen Verbrauchers erfolgt und das Ermitteln einer Entladezeitkonstante des elektrischen Verbrauchers in Abhängigkeit einer Länge eines oder mehrerer Zeiträume jeweils zwischen zwei aufeinander folgender Betriebsintervalle des elektrischen Verbrauchers erfolgt. Eine Entladezeitkonstante kann beispielsweise durch bilden des Mittelwerts über die Länge einer Vielzahl an Zeiträumen zwischen zweier aufeinanderfolgender Betriebsintervalle und/oder einer sonstigen mathematischen Funktion mit der Länge einer Vielzahl an Zeiträumen zwischen zweier aufeinanderfolgender Betriebsintervalle als Funktionsargument erfolgen.

Dies ermöglicht eine Abschätzung über die Länge der Zeiträume zwischen zwei Betriebsintervallen. Dadurch ist es möglich, den Startzeitpunkt eines weiteren Betriebsintervalls vorherzusagen und dadurch kann insbesondere eine mögliche zeitliche Verschiebung der Last (des Energieverbrauchs) abgeschätzt werden, ohne dass eine Wärme- bzw. Kälteanforderungen an den elektrischen Verbraucher dadurch beeinflusst wird.

Ein besonders durchdachtes Verfahren kann den zusätzlichen Schritt Ermitteln einer elektrischen Lastkapazität des elektrischen Verbrauchers in Abhängigkeit des erfassten Referenzenergieverbrauchs umfassen, wobei das Ermitteln des Lastverschiebepotentials in Abhängigkeit der elektrischen Lastkapazität des elektrischen Verbrauchers erfolgt und das Ermitteln der elektrischen Lastkapazität des elektrischen Verbrauchers in Abhängigkeit einer elektrischen Leistung des elektrischen Verbrauchers während der Dauer eines oder mehrerer Betriebsintervalle des elektrischen Verbrauchers und/oder in Abhängigkeit eines Energieverbrauchs während der Dauer eines oder mehrerer Betriebsintervalle des elektrischen Verbrauchers erfolgt. Eine Lastkapazität kann beispielsweise durch bilden des Mittelwerts über die elektrische Leistung bzw. über den elektrischen Energieverbrauch des elektrischen Verbrauchers während der Betriebsintervalle und/oder mittels einer sonstigen mathematischen Funktion mit der elektrischen Leistung bzw. mit dem elektrischen Energieverbrauch des elektrischen Verbrauchers als Funktionsargument ermittelt werden.

Dies hat den Vorteil, dass eine Abschätzung der elektrischen Leistung des elektrischen Verbrauchers während eines Lastbetriebs möglich ist. Dadurch kann abgeschätzt werden, in welchem Umfang Energie/elektrische Leistung einem Stromnetz durch den elektrischen Verbraucher während eines Lastbetriebs entzogen wird. Außerdem kann mittels der Lastkapazität, der Beladezeitkonstante und/oder der Entladezeitkonstante ermittelt werden, in wieweit eine Leistungsreduzierung bzw. Leistungserhöhung des elektrischen Verbrauchers möglich ist, so dass eine Erfüllung einer Wärme- bzw. Kälteanforderung an den elektrischen Verbraucher dadurch nicht bzw. nur geringfügig beeinflusst wird.

Des Weiteren kann mittels der Beladezeitkonstante, der Entladezeitkonstante und der Lastkapazität der elektrische Energieverbrauch des elektrischen Verbrauchers auf besonders einfache Art und Weise, beispielsweise analog zu einer elektrischen Kapazität/einem Kondensator mit einer Beladezeitkonstante, einer Entladezeitkonstante und einem Kapazitätswert, modelliert werden. In manchen Ausführungsformen kann ein Lastverschiebepotential Werte für die Beladezeitkonstante, die Entladezeitkonstante und die Lastkapazität umfassen. Dies hat den Vorteil, dass ein Lastverschiebepotential besonders einfach ermittelt werden kann und ein Lastverschiebepotential mit einer geringen Datenmenge übertragen werden kann.

In einem besonders genauen Verfahren kann das Erfassen des Referenzenergieverbrauchs den zusätzlichen Schritt Erfassen einer Gesamtbetriebszeit des elektrischen Verbrauchers innerhalb einer ersten vorgegebenen Zeitdauer beinhalten. In manchen Ausführungsformen kann das Verfahren den zusätzlichen Schritt Erfassen einer aktuellen Betriebszeit des elektrischen Verbrauchers in einem ersten aktuellen Zeitintervall umfassen. Das Ermitteln des Lastverschiebepotentials kann dann in Abhängigkeit der Gesamtbetriebszeit des elektrischen Verbrauchers und/oder zusätzlich in Abhängigkeit der aktuellen Betriebszeit des elektrischen Verbrauchers erfolgen.

Vorteilhafterweise kann die Länge der ersten vorgegebenen Zeitdauer mit der Länge des ersten aktuellen Zeitintervalls übereinstimmen. In manchen Ausführungsformen kann das Lastverschiebepotential zusätzlich in Abhängigkeit der Länge der ersten vorgegebenen Zeitdauer und/oder der Länge des ersten aktuellen Zeitintervalls bestimmt werden. Dies kann den Vorteil haben, dass eine besonders genaue Abschätzung bezüglich der Dauer eines Lastbetriebs des elektrischen Verbrauchers in einem vorgegebenen Zeitintervall gemacht werden kann und somit ein Lastverschiebepotential besonders exakt und zuverlässig ermittelt werden kann.

In einem besonders angepassten Verfahren kann das Erfassen des Referenzenergieverbrauchs den zusätzlichen Schritt Erfassen eines Gesamtenergieverbrauchs des elektrischen Verbrauchers innerhalb einer zweiten vorgegebenen Zeitdauer umfassen. In manchen Ausführungsformen kann das Verfahren den zusätzlichen Schritt Erfassen eines aktuellen Energieverbrauchs des elektrischen Verbrauchers in einem zweiten aktuellen Zeitintervall beinhalten. Das Ermitteln des Lastverschiebepotentials kann dann zusätzlich in Abhängigkeit des Gesamtenergieverbrauchs des elektrischen Verbrauchers und/oder zusätzlich in Abhängigkeit des aktuellen Energieverbrauchs des elektrischen Verbrauchers erfolgen.

Vorteilhafterweise stimmt die Länge der zweiten vorgegebenen Zeitdauer mit der Länge des zweiten aktuellen Zeitintervalls überein. In manchen Ausführungsformen kann die Länge der ersten vorgegebenen Zeitdauer mit der Länge der zweiten vorgegebenen Zeitdauer und/oder die Länge des ersten aktuellen Zeitintervalls mit der Länge des zweiten aktuellen Zeitintervalls übereinstimmen. In manchen Ausführungsformen kann das Lastverschiebepotential zusätzlich in Abhängigkeit der Länge der zweiten vorgegebenen Zeitdauer und der Länge des zweiten aktuellen Zeitintervalls bestimmt werden.

Dies kann den Vorteil haben, dass ein Energieverbrauch in einem vorgegebenen Zeitintervall besonders exakt abgeschätzt werden kann und somit ein Lastverschiebepotential des elektrischen Verbrauchers bezüglich des Energieverbrauchs in einem Zeitintervall mit besonders hoher Genauigkeit bestimmt werden kann.

Ein besonders zuverlässiges Verfahren kann die zusätzlichen Schritte Vorgeben einer Solltemperatur für einen Heiz- und/oder Kühlkreis des elektrischen Verbrauchers und/oder Erfassen einer Ist-Temperatur für einen Heiz- und/oder Kühlkreis des elektrischen Verbrauchers umfassen, wobei das Ermitteln des Lastverschiebepotentials zusätzlich in Abhängigkeit der erfassten Solltemperatur und/oder zusätzlich in Abhängigkeit der erfassten Ist-Temperatur erfolgt. Dadurch kann die Zuverlässigkeit des ermittelten Lastverschiebepotentials erhöht werden.

Ein besonders vorteilhaft weitergebildetes Verfahren kann die zusätzlichen Schritte Erfassen einer Außentemperatur als Referenzaußentemperatur in Verbindung mit dem Erfassen des Referenzenergieverbrauchs des elektrischen Verbrauchers und/oder Erfassen einer aktuellen Außentemperatur umfassen, wobei das Ermitteln des Lastverschiebepotentials zusätzlich in Abhängigkeit der Referenzaußentemperatur und/oder zusätzlich in Abhängigkeit der aktuellen Außentemperatur erfolgt. Dies kann den Vorteil haben, dass insbesondere Abhängigkeiten zwischen einem Energieverbrauch des elektrischen Verbrauchers und der Außentemperatur bei der Ermittlung des Lastverschiebepotentials mit berücksichtigt werden.

In einem besonders differenzierten Verfahren kann der elektrische Verbraucher zum Bereitstellen von Wärme und/oder Kälte in mehreren Kreisen eingerichtet sein, wobei ein Kreis ein Heiz- und/oder Kühlkreis ist. Das Erfassen des Referenzenergieverbrauchs des elektrischen Verbrauchers kann ein Erfassen der Ansteuerung der mehreren Kreise umfassen und das Ermitteln des Lastverschiebepotentials ein Ermitteln des Lastverschiebepotentials für mindestens einen Kreis der mehreren Kreise beinhalten. In manchen Ausführungsformen kann das Ermitteln des Lastverschiebepotentials des elektrischen Verbrauchers ein bestimmen des Lastverschiebepotentials für eine Gruppe von Kreisen, wobei die Gruppe einen oder mehrere (auch alle) Kreise des elektrischen Verbrauchers beinhalten kann, umfassen.

Dadurch können für einzelne Kreise oder Kreisgruppen (einer Gruppe von Kreisen) einzelne Lastverschiebepotentiale ermittelt werden, sodass einzelne Lastverschiebepotentiale differenzierter ermittelt werden können und die Genauigkeit der Lastverschiebepotentiale erhöht werden kann.

Ein besonders weiterentwickeltes Verfahren kann den zusätzlichen Schritt Ermitteln eines Überladungspotentials des elektrischen Verbrauchers und/oder der mehreren Kreise umfassen, wobei das Ermitteln des Lastverschiebepotentials zusätzlich in Abhängigkeit des ermittelten Überladungspotentials erfolgt. Ein Überladungspotential kann beispielsweise ein Maß dafür sein, inwieweit ein Lastbetrieb des elektrischen Verbrauchers über die eigentliche Dauer des Lastbetriebs ausgedehnt bzw. inwieweit die Leistung und somit der Energieverbrauch während eines Lastbetriebs des elektrischen Verbrauchers erhöht werden kann, ohne dass Schäden erzeugt bzw. die Effizienz wesentlich verschlechtert wird.

Dies kann den Vorteil haben, dass das Lastverschiebepotential eine Reserve/ einen Puffer (das Überladungspotential) umfasst und ein maximum des Lastverschiebepotentials ermittelt werden kann. Ein besonders großes Lastverschiebepotential des elektrischen Verbrauchers kann den Vorteil haben, dass die Flexibilität des elektrischen Verbrauchers, sowohl Stromspitzen als auch Lastspitzen in einem Energienetz zu kompensieren, erhöht werden kann.

Ein besonders flexibles Verfahren kann den zusätzlichen Schritt Bereitstellen des Lastverschiebepotentials umfassen, sodass der elektrische Verbraucher in Abhängigkeit des Lastverschiebepotentials des elektrischen Verbrauchers ansteuerbar ist, wobei eine Ansteuerung des elektrischen Verbrauchers insbesondere mittels eines Demand-Response Signals erfolgt. Dies kann den Vorteil haben, dass der elektrische Verbraucher besonders einfach zur Kompensation von Stromspitzen und Lastspitzen in einem Stromnetz verwendet werden kann.

Ein besonders zuverlässiges Verfahren kann den zusätzlichen Schritt Ausgeben einer Rückmeldung des elektrischen Verbrauchers, ob und/oder in wieweit eine Lastverschiebung des elektrischen Verbrauchers erfolgt, wenn ein Steuersignal, insbesondere ein Demand-Response Signal, an den elektrischen Verbraucher auf Grund des Lastverschiebepotentials übermittelt wird. Dies kann den Vorteil haben, dass eine Entscheidung einer Lastverschiebung des elektrischen Verbrauchers bei dem elektrischen Verbraucher bzw. bei dessen Bediener liegt und gleichzeitig sichergestellt wird, dass fehlerhafte Annahmen über eine Verschiebung der Last des elektrischen Verbrauchers vermieden werden.

Ein besonders genaues Verfahren kann die zusätzlichen Schritte Erfassen einer Heizkreistemperatur, Kühlkreistemperatur, einer Soll-Temperatur und/oder Gebäudetemperatur als Referenztemperaturen in Verbindung mit dem Erfassen des Referenzenergieverbrauchs des elektrischen Verbrauchers; und/oder Erfassen einer aktuellen Heizkreistemperatur, einer aktuellen Kühlkreistemperatur, einer aktuellen Soll-Temperatur und/oder einer aktuellen Gebäudetemperatur als aktuelle Temperaturen umfassen, wobei das Ermitteln des Lastverschiebepotentials zusätzlich in Abhängigkeit der Referenztemperaturen und/oder zusätzlich in Abhängigkeit der aktuellen Temperaturen erfolgt. Dies hat den Vorteil, dass die Genauigkeit des Lastverschiebepotentials verbessert werden kann, da Zusammenhänge zwischen einem Energieverbrauch des elektrischen Verbrauchers und den Referenztemperaturen ermittelt und zur Ermittlung des Lastverschiebepotentials herangezogen werden können.

Ein besonders weiterentwickeltes Verfahren kann die zusätzlichen Schritte Erfassen von Umweltfaktoren als Referenzumweltfaktoren in Verbindung mit dem Erfassen des Referenzenergieverbrauchs und/oder Erfassen von aktuellen Umweltfaktoren umfassen, wobei das Ermitteln des Lastverschiebepotentials zusätzlich in Abhängigkeit der Erfassten Referenzumweltfaktoren und/oder der in Abhängigkeit der aktuellen Umweltfaktoren erfolgt. Umweltfaktoren können beispielsweise Urlaubsdaten, Ferienzeiten, Wetterdaten, Feiertage, gesellschaftliche Ereignisse, Großveranstaltungen etc. sein. Dies kann den Vorteil haben, dass auch bei Unregelmäßigkeiten im Verhalten von Menschen ein Lastverschiebepotential zuverlässig ermittelt werden kann.

In manchen Ausführungsformen können Referenzdaten (Referenzenergieverbrauch, Referenztemperaturen etc.) und/oder aktuelle Daten (aktueller Energieverbrauch, aktuelle Temperaturen etc.) in Verbindung mit einem Zeitpunkt der Datenermittlung, wie einem Wochentag, einer Jahreszeit, einem Tageszeitpunkt, Arbeitstag, Feiertag etc. erfasst und das Lastpotential in Abhängigkeit mindestens einer dieser Verbindungen ermittelt werden.

Ein besonders angepasstes Verfahren kann die zusätzlichen Schritte Ermitteln eines Stromnetzes, das den elektrischen Verbraucher mit elektrischer Energie versorgt; und Zuordnen des elektrischen Verbrauchers zu einer Gruppe elektrischer Verbraucher in Abhängigkeit des ermittelten Stromnetzes umfassen. Das Ermitteln eines Stromnetzes kann beispielsweise ein Ermitteln eines Niederspannungsnetztes, eines Mittelspannungsnetzes, eines Hochspannungsnetzes und/oder eines Höchstspannungsnetzes umfassen.

Dies kann den Vorteil haben, dass das Lastverschiebepotential besonders effizient in dem Stromnetz, das den elektrischen Verbraucher mit Energie versorgt, genutzt werden kann und dadurch insbesondere lokale, regionale und/oder überregionale Schwankungen in einem komplexen Energieversorgungsnetz mit einer Vielzahl an Stromnetzten kompensiert werden können.

Vorteilhafterweise kann das Verfahren einen Schritt Ermitteln eines Stromnetzes, das den elektrischen Verbraucher mit elektrischer Energie versorgt, beinhalten, wobei der Schritt Bereitstellen des Lastverschiebepotentials ein Bereitstellen des Ergebnisses des Ermittelns des Stromnetzes umfasst. Dies kann den Vorteil haben, dass eine Vielzahl an elektrischen Verbrauchern auf einfache Art und Weise in Abhängigkeit deren Lastverschiebepotentiale, in Abhängigkeit der Stromnetze, die die elektrischen Verbraucher mit elektrischer Energie versorgen, und in Abhängigkeit von Lastspitzen und Stromspitzen in den Stromnetzen gesteuert werden können.

Ein besonders strukturiertes Verfahren kann einen zusätzlichen Schritt Zuordnen des elektrischen Verbrauchers zu einer Gruppe elektrischer Verbraucher in Abhängigkeit des Lastverschiebepotentials umfassen. Dies kann den Vorteil haben, dass eine Vielzahl an elektrischen Verbrauchern auf einfache Art und Weise in Abhängigkeit von Last- bzw. Stromspitzen auf einfache Art und Weise angesteuert werden kann.

Ein Aspekt der Anmeldung bezieht sich auf ein System zum Ermitteln eines Lastverschiebepotentials eines elektrischen Verbrauchers. Vorteilhafterweise kann der elektrische Verbraucher zur Wärmeerzeugung und/oder Kälteerzeugung in einem oder mehreren Heiz- und/oder Kühlkreisen eingerichtet sein. Das System kann eine Erfassungseinheit zum Erfassen eines elektrischen Energieverbrauchs des elektrischen Verbrauchers als Referenzenergieverbrauch des elektrischen Verbrauchers umfassen.

Die Erfassungseinheit kann vorzugsweise dazu eingerichtet sein, einen elektrischen Energieverbrauch des elektrischen Verbrauchers als Referenzenergieverbrauch des elektrischen Verbrauchers zu erfassen. Das Erfassen eines elektrischen Energieverbrauchs kann beispielsweise ein Erfassen eines elektrischen Energieverbrauchs in Abhängigkeit der Zeit, einer elektrischen Leistung in Abhängigkeit der Zeit etc. umfassen. Die Erfassungseinheit kann dazu beispielsweise eine oder mehrere digitale Schaltungen, insbesondere eine programmierbare Schaltung und/oder einen Mikrokontroller etc. umfassen. In manchen Ausführungsformen kann eine Steuereinheit des elektrischen Energieverbrauchers die Erfassungseinheit umfassen.

In manchen Ausführungsformen kann ein Vorgeben eines gewünschten Energieverbrauchs an den elektrischen Verbraucher, um ein Anspruchsverhalten des elektrischen Verbrauchers zu ermitteln, entfallen.

Des Weiteren kann das System eine Ermittlungseinheit zum Ermitteln eines Lastverschiebepotentials des elektrischen Verbrauchers in Abhängigkeit des Referenzenergieverbrauchs des elektrischen Verbrauchers umfassen. Die Ermittlungseinheit kann vorzugsweise dazu eingerichtet sein, ein Lastverschiebepotential des elektrischen Verbrauchers in Abhängigkeit des Referenzenergieverbrauchs des elektrischen Verbrauchers zu ermitteln. Die Ermittlungseinheit kann dazu beispielsweise eine oder mehrere analoge und/oder digitale Schaltungen, insbesondere Recheneinheiten, umfassen. Das System hat den Vorteil, dass ein Lastverschiebepotential des elektrischen Verbrauchers besonders effizient ermittelt werden kann.

In manchen Ausführungsformen kann eine Signalverarbeitungseinheit des elektrischen Verbrauchers die Erfassungseinheit und/oder die Ermittlungseinheit umfassen. Dies hat den Vorteil, dass das System besonders platzsparend und integriert zur Verfügung gestellt werden kann.

In manchen Ausführungsformen kann das System eine Signalverarbeitungseinheit beinhalten, wobei die Signalverarbeitungseinheit die Erfassungseinheit und/oder die Ermittlungseinheit umfasst. Dies kann den Vorteil haben, dass das System unabhängig von der Funktionsweise und den Schnittstellen des elektrischen Verbrauchers ein Lastverschiebepotential des elektrischen Verbrauchers ermitteln kann.

In besonders weitergebildeten Ausführungsformen kann das System eine Kommunikationseinheit umfassen, die dazu eingerichtet ist, ein Angebot für eine Lastverschiebung in Abhängigkeit des ermittelten Lastverschiebepotentials zu versenden und/oder eine Bedarfsanfrage für eine Lastverschiebung zu empfangen. Dies kann den Vorteil haben, dass das System besonders einfach mit einem Energieversorgungssystem kommunizieren und das ermittelte Lastverschiebepotential besonders zielführend zum Verschieben einer Last verwendet werden kann.

In manchen Ausführungsformen kann die Erfassungseinheit zum Erfassen des elektrischen Energieverbrauchs einer Vielzahl von elektrischen Verbrauchern eingerichtet sein und/oder die Ermittlungseinheit zum Ermitteln des Lastverschiebepotentials einer Vielzahl an elektrischen Verbrauchern eingerichtet sein. Dies kann den Vorteil haben, dass die Anzahl der Erfassungseinheiten und/oder die Anzahl der Ermittlungseinheiten reduziert und dadurch Kosten gespart werden können.

In manchen Ausführungsformen kann das System zum Ausführen eines oben gezeigten Verfahrens eingerichtet sein.

Ein Aspekt der Anmeldung bezieht sich auf ein Computerprogramm-Produkt zum Ermitteln eines Lastverschiebepotentials eines elektrischen Verbrauchers. Das Computerprogramm-Produkt umfasst Befehle, die bei der Ausführung des Programms durch einen Computer diesen veranlassen, die Schritte des Verfahrens nach einem der Ansprüche 1 bis 15 auszuführen. Ein Computer kann beispielsweise ein Microcontroller, eine programmierbare Logikschaltung, eine digitale Schaltung, ein Halbleiterchip, ein Prozessor etc. sein. Befehle können in einem oder mehreren Softwareprogrammen, Programmcodes etc. wiedergegeben sein.

### Beschreibung der Figuren

Fig. 1 zeigt schematisch ein Verfahren gemäß einer Ausführungsform der Erfindung.
Fig. 2 bis 6 zeigen jeweils schematisch ein Verfahren gemäß einer Ausführungsform der Erfindung basierend auf dem in Fig. 1 gezeigten Verfahren.
Fig. 7 zeigt schematisch einen Graphen zur Ermittlung eines Lastverschiebepotentials gemäß einer Ausführungsform der Erfindung.
Fig. 8 zeigt schematisch einen Zusammenhang zwischen einer Tagesmitteltemperatur und einer Heizleistung bzw. einer Kühlleistung eines elektrischen Verbrauchers gemäß einer Ausführungsform der Erfindung.
Fig. 9 zeigt schematisch eine Leistung eines elektrischen Verbrauchers in Abhängigkeit der Zeit gemäß einer Ausführungsform der Erfindung.
Fig. 10 zeigt schematisch ein System gemäß einer Ausführungsform der Erfindung.

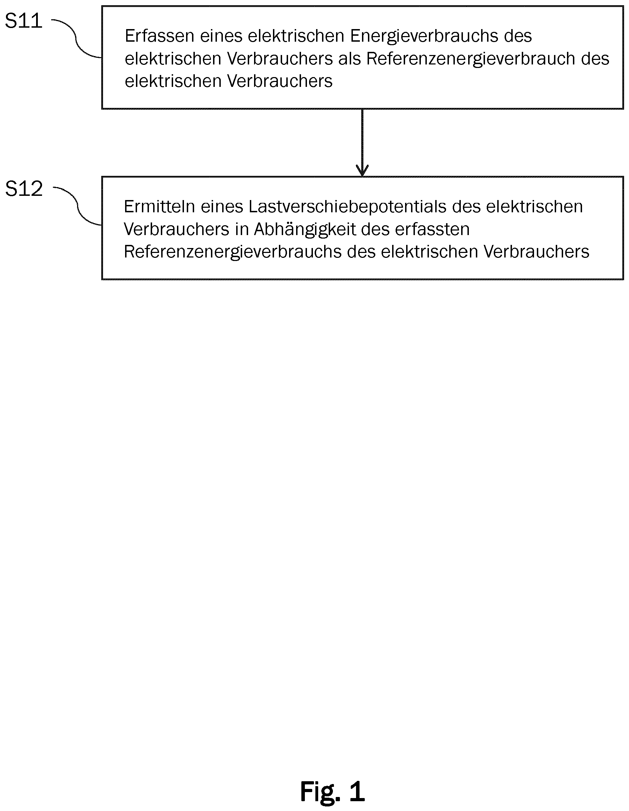

Fig. 1 zeigt schematisch ein Verfahren gemäß einer Ausführungsform der Erfindung. Vorteilhafterweise kann das Verfahren dazu eingerichtet sein, ein Lastverschiebepotential eines elektrischen Verbrauchers zu ermitteln. Der elektrische Verbraucher kann insbesondere zur Wärmeerzeugung und/oder Kälteerzeugung in einem oder mehreren Heiz- und/oder Kühlkreisen eingerichtet sein. Der elektrische Verbraucher kann insbesondere eine Wärmepumpe, ein Kühlaggregat, ein Heizstab, ein elektrischer Warmwasserspeicher etc. sein. Das Erfassen kann beispielsweise mittels einer Erfassungseinheit erfolgen.

In einem ersten Schritt S11 wird ein elektrischer Energieverbrauch des elektrischen Verbrauchers als Referenzenergieverbrauch des elektrischen Verbrauchers erfasst. Das Erfassen des elektrischen Energieverbrauchs des elektrischen Verbrauchers kann insbesondere ein Aufzeichnen des elektrischen Energieverbrauchs des elektrischen Verbrauchers in Abhängigkeit der Zeit umfassen.

In einem weiteren Schritt S12 wird ein Lastverschiebepotential des elektrischen Verbrauchers in Abhängigkeit des erfassten Referenzenergieverbrauchs des elektrischen Verbrauchers, insbesondere mittels einer Ermittlungseinheit, ermittelt. Das Lastverschiebepotential des elektrischen Verbrauchers kann insbesondere Informationen enthalten, inwieweit eine zeitliche Verschiebung eines Energieverbrauchs des elektrischen Verbrauchers möglich ist. In manchen Ausführungsformen kann ein Lastverschiebepotential Informationen enthalten, inwieweit ein Energieverbrauch des elektrischen Verbrauchers, insbesondere hinsichtlich der Leistung und/oder des Zeitpunkts angepasst werden kann.

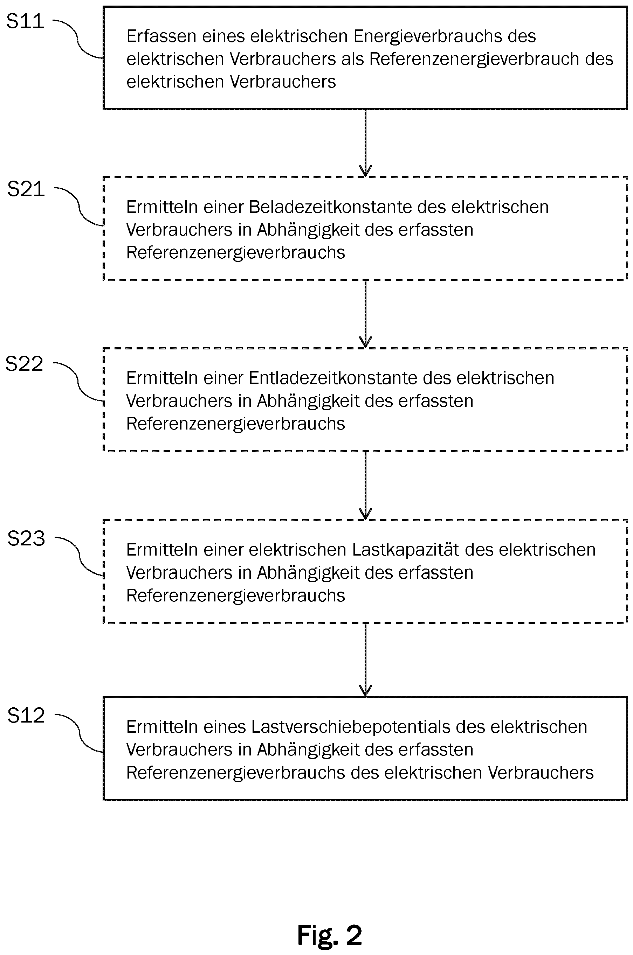

Fig. 2 zeigt schematisch ein Verfahren gemäß einer Ausführungsform der Erfindung. Das in Fig. 2 gezeigte Verfahren basiert auf dem in Fig. 1 gezeigten Verfahren. Das in Fig. 2 gezeigte Verfahren unterscheidet sich von dem in Fig. 1 gezeigten Verfahren dahingehend, dass es Schritte S21, S22 und/oder S23 umfassen kann, die jeweils optional sind. In dem optionalen Schritt S21 wird eine Beladezeitkonstante des elektrischen Verbrauchers in Abhängigkeit des erfassten Differenzenergieverbrauchs ermittelt. Entsprechend kann das Ermitteln des Lastverschiebepotentials in Abhängigkeit der Beladezeitkonstante des elektrischen Verbrauchers erfolgen. Das Ermitteln einer Beladezeitkonstante des elektrischen Verbrauchers kann in Abhängigkeit einer Dauer eines oder mehrerer Betriebsintervalle des elektrischen Verbrauchers erfolgen. Vorteilhafterweise bezieht sich ein Betriebsintervall auf einen Lastbetrieb des elektrischen Verbrauchers. In manchen Ausführungsformen kann sich ein Betriebsintervall auf einen Betrieb des elektrischen Verbrauchers beziehen, der den Zweck hat Wärme zu erzeugen und/oder Kälte zu erzeugen. Die Beladezeitkonstante kann beispielsweise mittels einer Ermittlungseinheit ermittelt werden.

In einem weiteren optionalen Schritt S22 kann eine Entladezeitkonstante des elektrischen Verbrauchers in Abhängigkeit des erfassten Referenzenergieverbrauchs ermittelt werden. Entsprechend kann das Ermitteln des Lastverschiebepotentials im Schritt S12 in Abhängigkeit der Entladezeitkonstante des elektrischen Verbrauchers erfolgen. Das Ermitteln einer Entladezeitkonstante des elektrischen Verbrauchers kann in Abhängigkeit einer Länge eines oder mehrerer Zeiträume jeweils zwischen zwei aufeinanderfolgender Betriebsintervalle des elektrischen Verbrauchers erfolgen. Die Entladezeitkonstante kann beispielsweise mittels einer Ermittlungseinheit ermittelt werden.

In einem optionalen Schritt S23 kann eine elektrische Lastkapazität des elektrischen Verbrauchers in Abhängigkeit des erfassten Referenzenergieverbrauchs ermittelt werden. Das Ermitteln des Lastverschiebepotentials im Schritt S12 kann entsprechend in Abhängigkeit der elektrischen Lastkapazität des elektrischen Verbrauchers erfolgen. In manchen Ausführungsformen kann das Ermitteln der elektrischen Lastkapazität des elektrischen Verbrauchers in Abhängigkeit einer elektrischen Leistung des elektrischen Verbrauchers während der Dauer eines oder mehrerer Betriebsintervalle des elektrischen Verbrauchers und/oder in Abhängigkeit eines Energieverbrauchs während der Dauer eines oder mehrerer Betriebsintervalle des elektrischen Verbrauchers erfolgen. Die elektrische Lastkapazität kann beispielsweise mittels einer Ermittlungseinheit ermittelt werden.

Mithilfe der Schritte S21, S22 und/oder S23 kann ein elektrischer Verbraucher auf einfache Weise mit einem Modell einer Kapazität/eines Kondensators dargestellt werden. Dies hat den Vorteil, dass ein Lastverschiebepotential besonders einfach und effizient ermittelt werden kann. In manchen Ausführungsformen kann ein Lastverschiebepotential in Abhängigkeit eines Verhältnisses zwischen Beladezeitkonstante und Entladezeitkonstante ermittelt werden.

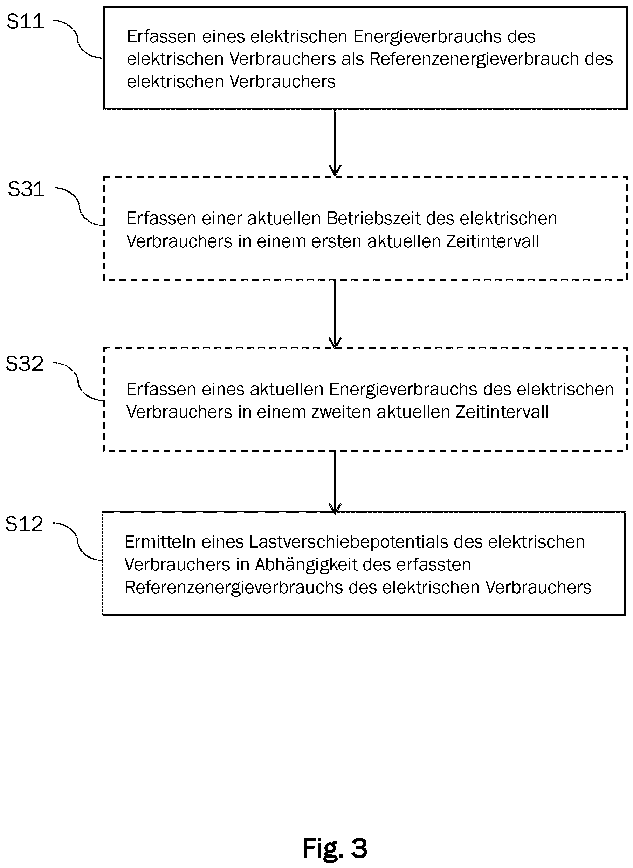

Fig. 3 zeigt schematisch ein Verfahren gemäß einer Ausführungsform der Erfindung. Das in Fig. 3 gezeigte Verfahren basiert auf dem in Fig. 1 gezeigten Verfahren und unterscheidet sich dahingehend, dass es die Schritte S31 und S32 umfasst, die jeweils optional sind.

In manchen Ausführungsformen kann der Schritt S11 einen Schritt Erfassen einer Gesamtbetriebszeit des elektrischen Verbrauchers innerhalb einer ersten vorgegebenen Zeitdauer umfassen. Entsprechend kann das Ermitteln des Lastverschiebepotentials im Schritt S12 in Abhängigkeit der Gesamtbetriebszeit des elektrischen Verbrauchers innerhalb der ersten vorgegebenen Zeitdauer erfolgen.

In manchen Ausführungsformen kann das Verfahren einen Schritt S31 Erfassen einer aktuellen Betriebszeit des elektrischen Verbrauchers in einem ersten aktuellen Zeitintervall, insbesondere mittels einer Erfassungseineheit, umfassen. Das Ermitteln des Lastverschiebepotentials im Schritt S12 kann dann entsprechend zusätzlich in Abhängigkeit der aktuellen Betriebszeit des elektrischen Verbrauchers im ersten aktuellen Zeitintervall erfolgen.

Dies kann den Vorteil haben, dass wiederkehrende Muster im Energieverbrauch des elektrischen Verbrauchers Zeitintervallen zugeordnet werden können und dadurch der Energieverbrauch des elektrischen Verbrauchers für die Zukunft abgeschätzt werden kann. Diese Abschätzung kann wiederum zur Ermittlung des Lastverschiebepotentials herangezogen werden, so dass sich die Genauigkeit und die Zuverlässigkeit des Lastverschiebepotentials erhöhen lässt. Durch das Erfassen einer aktuellen Betriebszeit in einem ersten aktuellen Zeitintervall kann diese Abschätzung zusätzlich verbessert werden.

In manchen Ausführungsformen kann der Schritt S11 einen Schritt Erfassen eines Gesamtenergieverbrauchs des elektrischen Verbrauchers innerhalb einer zweiten vorgegebenen Zeitdauer umfassen. Entsprechend kann das Ermitteln des Lastverschiebepotentials im Schritt S12 in Abhängigkeit des Gesamtenergieverbrauchs des elektrischen Verbrauchers erfolgen. In manchen Ausführungsformen kann das Verfahren einen optionalen Schritt S32 Erfassen eines aktuellen Energieverbrauchs des elektrischen Verbrauchers in einem zweiten aktuellen Zeitintervall, insbesondere mittels einer Erfassungseinheit, umfassen. Entsprechend kann dann das Ermitteln des Lastverschiebepotentials im Schritt S12 in Abhängigkeit des aktuellen Energieverbrauchs des elektrischen Verbrauchers erfolgen. Dies kann den Vorteil haben, dass verschiedene Betriebsarten des elektrischen Verbrauchers, die einen unterschiedlichen Energieverbrauch aufweisen können, berücksichtigt werden. Folglich kann dadurch die Genauigkeit des Lastverschiebepotentials, insbesondere hinsichtlich des Energieverbrauchs des elektrischen Verbrauchers, verbessert werden.

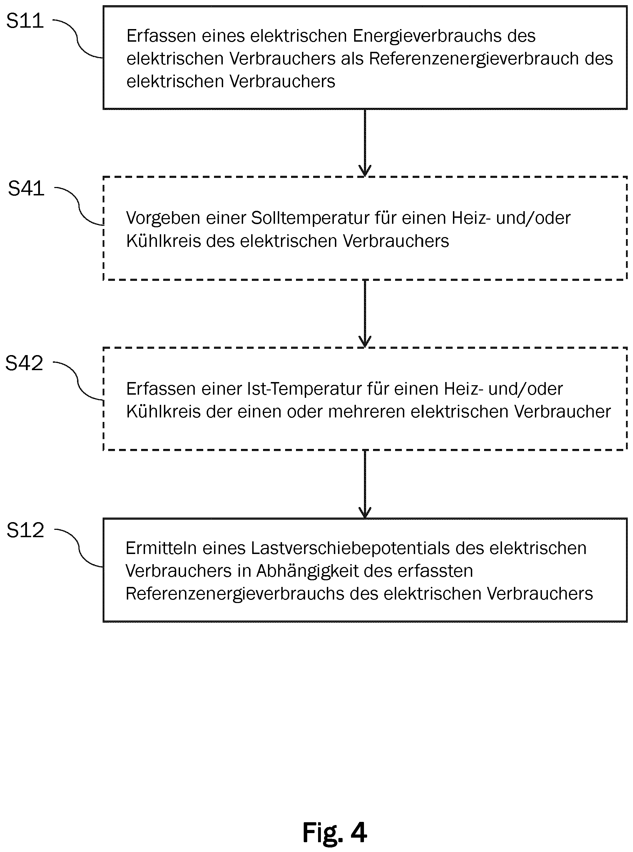

Fig. 4 zeigt schematisch ein Verfahren gemäß einer Ausführungsform der Erfindung. Das in Fig. 4 gezeigte Verfahren basiert auf dem in Fig. 1 gezeigten Verfahren und unterscheidet sich von diesem dahingehend, dass es die Schritte S41 und/oder S42 umfasst, die jeweils optional sind. Im Schritt S41 wird eine Solltemperatur für einen Heiz- und/oder Kühlkreis des elektrischen Verbrauchers vorgegeben. In einem Schritt S42 wird eine Ist-Temperatur für einen Heiz- und/oder Kühlkreis des elektrischen Verbrauchers erfasst. Das Ermitteln des Lastverschiebepotentials kann dann in Abhängigkeit der vorgegebenen Solltemperatur und/oder in Abhängigkeit der erfassten Ist-Temperatur erfolgen. Vorteilhafterweise kann eine Solltemperatur beispielsweise mittels einer Speichereinheit bzw. einer Benutzerschnittstelle vorgegeben werden. In manchen Ausführungsformen kann eine Ist-Temperatur eines Heiz- und/oder Kühlkreises beispielsweise mittels Temperatursensoren erfasst werden.

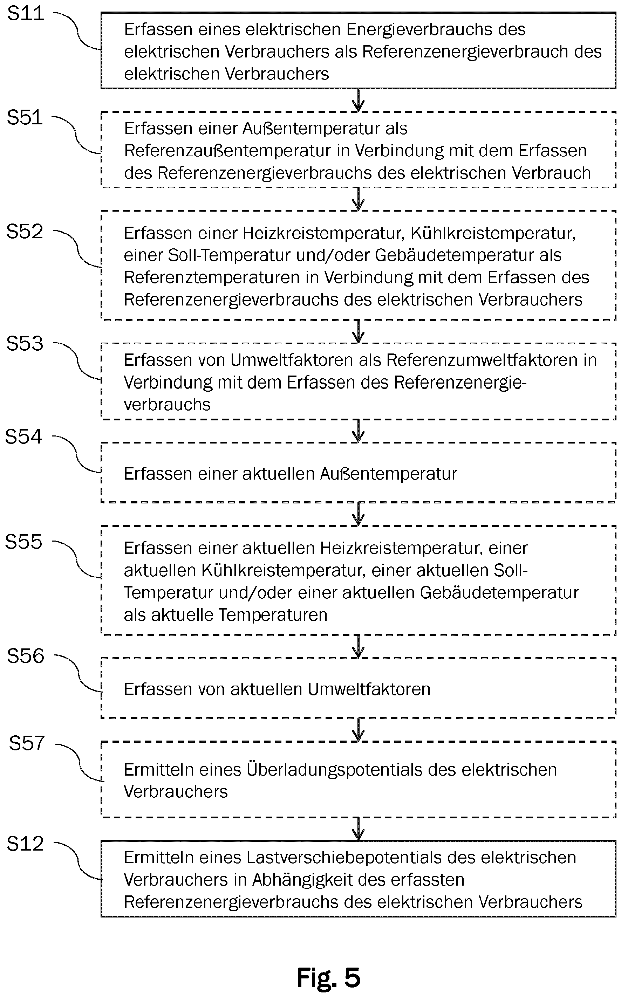

Fig. 5 zeigt schematisch ein Verfahren gemäß einer Ausführungsform der Erfindung. Das in Fig. 5 gezeigte Verfahren basiert auf dem in Fig. 1 gezeigten Verfahren und unterscheidet sich von diesem dahingehend, dass es die zusätzlichen Schritte S51 bis S57, die jeweils optional sind, umfasst. Das Verfahren kann einen Schritt S51 Erfassen einer Außentemperatur als Referenzaußentemperatur in Verbindung mit dem Erfassen des Referenzenergieverbrauchs des elektrischen Verbrauchers beinhalten. Entsprechend kann das Ermitteln des Lastverschiebepotentials in Abhängigkeit der Referenzaußentemperatur erfolgen. In manchen Ausführungsformen kann das Verfahren einen Schritt S52 Erfassen einer Heizkreistemperatur, Kühlkreistemperatur, einer Solltemperatur und/oder Gebäudetemperatur als Referenztemperaturen in Verbindung mit dem Erfassen des Referenzenergieverbrauchs des elektrischen Verbrauchers beinhalten. Entsprechend kann das Ermitteln des Lastverschiebepotentials im Schritt S12 in Abhängigkeit der Referenztemperaturen erfolgen.

In manchen Ausführungsformen kann das Verfahren einen Schritt S53 Erfassen von Umweltfaktoren als Referenzumweltfaktoren in Verbindung mit dem Erfassen des Referenzenergieverbrauchs beinhalten. Entsprechend kann das Ermitteln des Lastverschiebepotentials in Abhängigkeit der erfassten Referenzumweltfaktoren erfolgen. Umweltfaktoren können beispielsweise Feiertage, gesellschaftliche Ereignisse, Urlaubszeiten, Ferienzeiten etc. sein.

Dies kann den Vorteil haben, dass Einflüsse, die einen Lastbetrieb des elektrischen Verbrauchers beeinflussen, beim Erfassen des Referenzenergieverbrauchs des elektrischen Verbrauchers miterfasst werden und somit bei der Bestimmung des Lastverschiebepotentials mitberücksichtigt werden können.

In manchen Ausführungsformen kann das Verfahren einen Schritt S54 Erfassen einer aktuellen Außentemperatur beinhalten. Entsprechend kann das Ermitteln des Lastverschiebepotentials in Abhängigkeit der Außentemperatur erfolgen. In manchen Ausführungsformen kann das Verfahren einen Schritt S55 Erfassen einer aktuellen Heizkreistemperatur, einer aktuellen Kühlkreistemperatur, einer aktuellen Solltemperatur und/oder einer aktuellen Gebäudetemperatur als aktuelle Temperatur umfassen. Das Lastverschiebepotential kann dann in Abhängigkeit der aktuellen Temperaturen ermittelt werden. In manchen Ausführungsformen kann das Verfahren einen Schritt S56 Erfassen von aktuellen Umweltfaktoren umfassen, so dass das Lastverschiebepotential in Abhängigkeit der aktuellen Umweltfaktoren ermittelt werden kann.

In besonders fortschrittlichen Ausführungsformen kann das Verfahren einen Schritt S57 Ermitteln eines Überladungspotentials des elektrischen Verbrauchers umfassen. Das Ermitteln des Lastverschiebepotentials im Schritt S12 kann dann in Abhängigkeit des ermittelten Überladungspotentials erfolgen. In manchen Ausführungsformen kann das Ermitteln des Überladungspotentials durch Auswerten des Referenzenergieverbrauchs erfolgen. In manchen Ausführungsformen kann ein Überladungspotential beispielsweise durch einen Benutzer mittels einer Benutzerschnittstelle bereitgestellt werden. In manchen Ausführungsformen kann das Überladungspotential durch die Heizkreise, Kühlkreise und/oder den elektrischen Verbraucher vorgegeben sein.

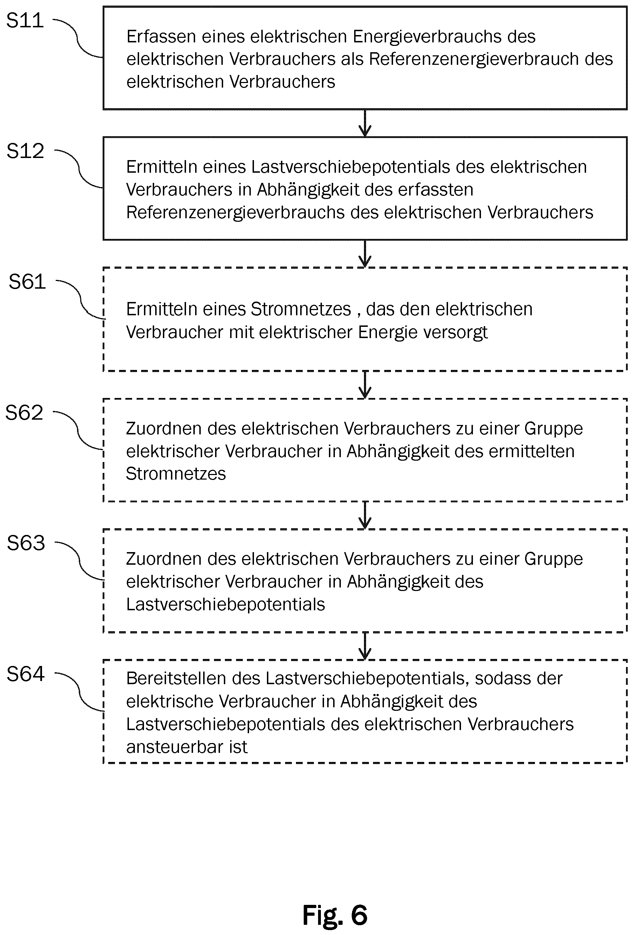

Fig. 6 zeigt schematisch ein Verfahren gemäß einer Ausführungsform der Erfindung. Das in Fig. 6 gezeigte Verfahren basiert auf dem in Fig. 1 gezeigten Verfahren und unterscheidet sich von diesem dahingehend, dass es Schritte S61 bis S64, die jeweils optional sind, beinhalten kann.

Das Verfahren kann optional die Schritte S61 Ermitteln eines Stromnetzes, das den elektrischen Verbraucher mit elektrischer Energie versorgt und den Schritt S62 Zuordnen des elektrischen Verbrauchers zu einer Gruppe elektrischer Verbraucher in Abhängigkeit des ermittelten Stromnetzes umfassen. Beispiele für Stromnetze sind Niederspannungsnetze, Mittelspannungsnetze, Hochspannungsnetze, Höchstspannungsnetze und/oder Gleichstromnetze. Dies kann den Vorteil haben, dass Stromspitzen, bzw. Lastspitzen in einem Stromnetz mittels des Lastverschiebepotentials eines elektrischen Verbrauchers, der in besagtem Stromnetz mit elektrischer Energie versorgt wird, kompensiert werden können.

Des Weiteren kann das Verfahren einen Schritt S63 Zuordnen des elektrischen Verbrauchers zu einer Gruppe elektrischer Verbraucher in Abhängigkeit des Lastverschiebepotentials beinhalten. Dadurch kann eine Vielzahl an elektrischen Verbrauchern auf besonders einfache Art zur Kompensation von Strom bzw. Lastspitzen herangezogen werden.

Das Verfahren kann außerdem einen Schritt S64 Bereitstellen des Lastverschiebepotentials, so dass der elektrische Verbraucher in Abhängigkeit des Lastverschiebepotentials des elektrischen Verbrauchers ansteuerbar ist, umfassen. Eine Ansteuerung kann dabei beispielsweise mittels eines Demand-Response-Signals erfolgen. Dies kann den Vorteil haben, dass das Lastverschiebepotential einem Energieversorger, der den elektrischen Verbraucher mit elektrischer Energie versorgt, bereitgestellt werden kann, ohne dass private Informationen, beispielsweise über das Heizverhalten von Bewohner eines Hauses, das mittels des elektrischen Verbrauchers geheizt bzw. gekühlt wird, weitergegeben werden.

Vorteilhafterweise können die in den Fig. 1 bis 6 gezeigten Verfahren und Verfahrensschritte miteinander kombiniert werden. Insbesondere kann das Ermitteln einer Beladezeitkonstante (S21), einer Entladezeitkonstante (S22) und/oder einer elektrischen Lastkapazität (S23) in Abhängigkeit eines oder mehrerer der in den Figurenbeschreibungen der Figuren 3 bis 6 ermittelten und/oder erfassten Parameter/Werte erfolgen. Bei den in den Fig. 1 bis 6 gezeigten Verfahren können Schritte vertauscht, miteinander kombiniert, weggelassen, hinzugefügt, zusammengefasst, parallel ausgeführt und/oder in mehrere Schritte aufgeteilt werden, ohne dass der Kern der Erfindung dadurch beeinflusst wird.

In manchen Ausführungsformen kann der elektrische Verbraucher zum Bereitstellen von Wärme oder Kälte in mehreren Kreisen eingerichtet sein, wobei ein Kreis ein Heiz- und/oder Kühlkreis ist. Das Erfassen des Referenzenergieverbrauchs des elektrischen Verbrauchers kann dann ein Erfassen der Ansteuerung der mehreren Kreise umfassen. Entsprechend kann das Ermitteln des Lastverschiebepotentials ein Ermitteln des Lastverschiebepotentials für mindestens einen Kreis der mehreren Kreise umfassen. In manchen Ausführungsformen können mehrere Kreise zu einer Kreisgruppe zusammengefasst werden, für die gemeinsam ein Lastverschiebepotential ermittelt wird. In manchen Ausführungsformen kann entsprechend eine Beladezeitkonstante, eine Entladezeitkonstante und/oder eine Lastkapazität für mindestens einen Kreis der einen oder mehreren Kreise oder für eine Kreisgruppe ermittelt werden.

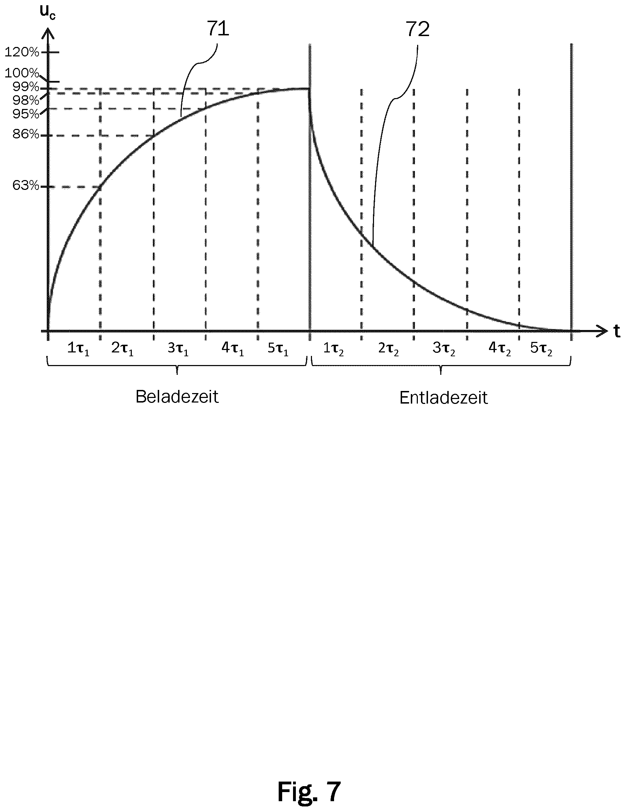

Fig. 7 zeigt schematisch einen Graphen zur Ermittlung eines Lastverschiebepotentials gemäß einer Ausführungsform der Erfindung. Auf der X-Achse ist die Zeit aufgetragen. Über die Y-Achse ist ein Ladezustand in Prozent angegeben. Der in Fig. 7 dargestellte Graph lässt sich in zwei Abschnitte 71, 72 untergliedern. Der Abschnitt 71 hat in etwa die Form einer logarithmischen Funktion, der Abschnitt 72 hat in etwa die Form einer exponentiellen Funktion. Der Graph, umfassend die Abschnitte 71 und 72, zeigt beispielhaft den Ladezustand eines oder mehrerer Heiz- bzw. Kühlkreise, die mittels eines elektrischen Verbrauchers mit Wärme bzw. Kälte versorgt werden.

Im Abschnitt 71 erzeugt der elektrische Verbraucher Wärme bzw. Kälte, so dass die Heiz- bzw. Kühlkreise entsprechend vorgegebenen Solltemperaturen analog einer Kapazität bzw. eines Kondensators durch den elektrischen Verbraucher gesättigt werden. Der elektrische Verbraucher befindet sich währenddessen in einem Lastbetrieb, so dass Wärme für einen oder mehrere Heizkreise bzw. Kälte für einen oder mehrere Kühlkreise erzeugt wird. Der Zeitraum eines Lastbetriebs kann als Beladezeit bezeichnet werden. In Fig. 7 ist ersichtlich, dass nach einem Zeitraum 1τ₁ ein Ladezustand von 63%, nach 2τ₁ ein Ladezustand von etwa 86%, nach 3τ₁ ein Ladezustand von etwa 95% und nach 4τ₁ ein Ladezustand von etwa 98% erreicht wird.

In manchen Ausführungsformen kann der Wert τ₁ die Beladezeitkonstante sein. In diesem Graphen wird bei einem Ladezustand von etwa 99% und nach etwa 5τ₁ vom Lastbetrieb des elektrischen Verbrauchers in einen Stand-by-Betrieb gewechselt bzw. der elektrische Verbraucher ausgeschaltet, so dass die Heiz- bzw. Kühlkreise nicht weiter durch den elektrischen Verbraucher in einem Lastbetrieb mit Wärme bzw. Kälte versorgt werden. In manchen Ausführungsformen kann ein Lastbetrieb bereits bei einem niedrigeren vorgegebenen Ladezustand verlassen werden, insbesondere so dass eine Reserve (Überladungspotential) gewahrt wird. Wie im in Fig. 7 gezeigten Graphen ersichtlich, nimmt daraufhin der Ladezustand in etwa exponentiell ab, siehe Graphabschnitt 72, so dass in den Heizkreisen bzw. Kühlkreisen erzeugte Reserven (Ladezustand) mit der Zeit verbraucht sind. Entsprechend kann mittels des Graphabschnitts 72 eine Entladezeitkonstante, insbesondere eine Entladezeitkonstante τ₂, basierend auf dem Graphabschnitt 72 ermittelt werden.

Im in Fig. 7 gezeigten Graphen zeigt der Ladezustand einen Ladezustand der Lastkapazität des elektrischen Verbrauchers in Prozent an. Die Lastkapazität gibt somit ein Maß für die Speicherreserven der mittels des elektrischen Verbrauchers mit Wärme bzw. Kälte versorgten Heiz- bzw. Kühlkreise wieder. In manchen Ausführungsformen kann der Ladezustand mehr als 100% betragen, so dass eine Überladung in Abhängigkeit eines Überladungspotentials möglich ist.

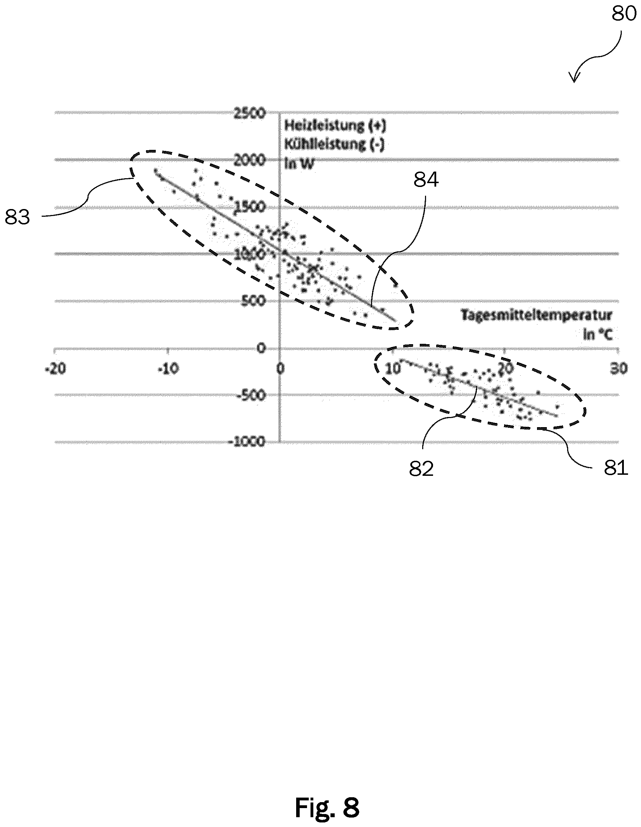

Fig. 8 zeigt schematisch einen Zusammenhang zwischen einer Tagesmitteltemperatur und einer Heizleistung bzw. einer Kühlleistung eines elektrischen Verbrauchers gemäß einer Ausführungsform der Erfindung. In Fig. 8 ist ein Graph 80 gezeigt, bei dem über die X-Achse die Tagesmitteltemperatur in Grad Celsius und über die Y-Achse die Heizleistung (positive Werte) bzw. die Kühlleistung (negative Werte) in Watt aufgetragen ist. Aus dem Graphen 80 kann entnommen werden, dass ein direkter Zusammenhang zwischen der Tagesmitteltemperatur und einer Heizleistung vorhanden ist, so dass die Messpunkte 83 mittels einer Geradengleichung 84 oder einer anderen mathematischen Funktion als Zusammenhang zwischen Tagesmitteltemperatur und Heizleistung wiedergegeben/genähert/interpoliert werden können.

Analoges gilt für die Kühlleistung. Dem Graphen 80 ist zu entnehmen, dass die Messpunkte 81 eine Wechselwirkung zwischen Tagesmitteltemperatur und Kühlleistung wiedergeben. Diese Wechselwirkung kann mittels einer Geradengleichung 82 oder einer anderen mathematischen Funktion genähert/wiedergegeben/interpoliert werden. Ausgehend davon ist es möglich, einen Energieverbrauch eines elektrischen Verbrauchers zum Versorgen eines Kühlkreises mit Kälte in Abhängigkeit einer Tagesmitteltemperatur näherungsweise abzuschätzen. Dies hat den Vorteil, dass in Abhängigkeit der Tagesmitteltemperatur ein Energieverbrauch eines elektrischen Verbrauchers abschätzbar ist und ein Lastverschiebepotential entsprechend in Abhängigkeit einer Tagesmitteltemperatur ermittelt werden kann.

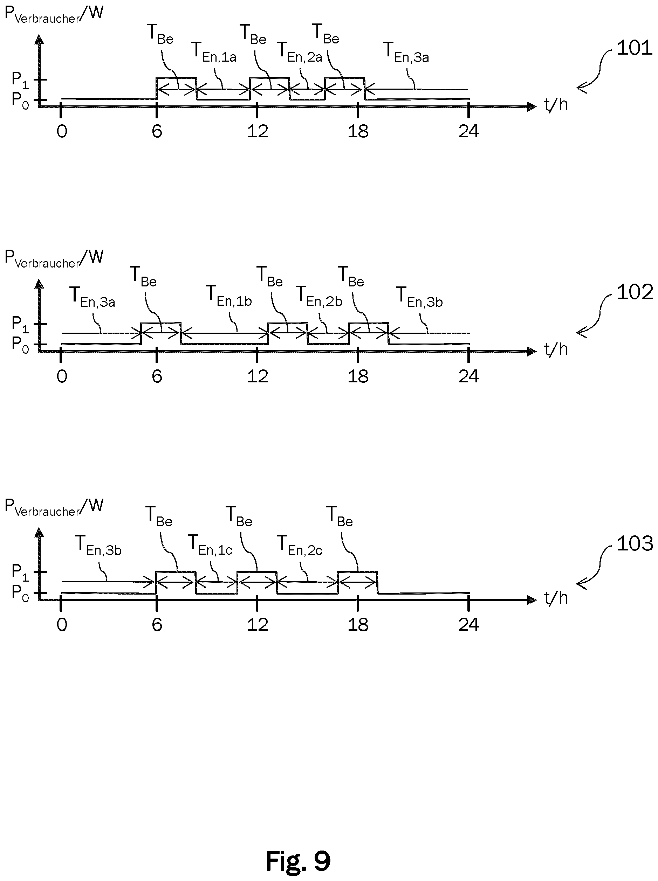

Fig. 9 zeigt schematisch eine Leistung eines elektrischen Verbrauchers in Abhängigkeit der Zeit gemäß einer Ausführungsform der Erfindung. In Fig. 9 sind dazu drei Graphen gezeigt, wobei der Graph 101 einen Leistungsverlauf (Leistung des elektrischen Verbrauchers in Abhängigkeit der Zeit) für einen ersten Tag, der Graph 102 einen Leistungsverlauf für einen zweiten Tag und der Graph 103 einen Leistungsverlauf für einen dritten Tag in Abhängigkeit der Zeit zeigen. Auf der X-Achse ist die Zeit aufgetragen in Stunden und auf der Y-Achse die elektrische Leistung des elektrischen Verbrauchers. Während einer Dauer T_{Be} eines Betriebsintervalls (Lastbetrieb) wird der elektrische Verbraucher mit einer Leistung P₁ betrieben. Während der Zeiträume T_{En,1a}, T_{En,2a}, T_{En,3a}, T_{En,1b}, T_{En,2b}, T_{En,3b}, T_{En,1c}, T_{En,2c} zwischen zwei Betriebsintervallen wird der elektrische Verbraucher mit einer Leistung P_{O} , insbesondere mit P_{O} = 0 betrieben (Off-Modus bzw. Standby-Modus).

Aus den Graphen 101 bis 103 kann entnommen werden, dass sich der elektrische Verbraucher jeweils um etwa 6 Uhr, 12 Uhr und 18 Uhr in einem Lastbetrieb für die Dauer T_{Be} befindet. Außerdem ist ersichtlich, dass die Zeiträume T_{En,1a}, T_{En,1b}, T_{En,1c} in etwa eine gleiche Dauer aufweisen. Analoges gilt für die Zeiträume T_{En,2a}, T_{En,2b}, T_{En,2c}. Auch die Zeiträume T_{En,3a} und T_{En,3b} weisen in etwa die gleiche Länge auf. In manchen Ausführungsformen können die Zeiträume auch unterschiedliche Dauern aufweisen oder andere Regelmäßigkeiten aufzeigen (z.B. morgens immer ein langer Lastbetrieb, Abends immer kurz ein Lastbetrieb, oder ähnlich). Diese Regelmäßigkeiten können für die Ermittlung eines Lastverschiebepotentials genutzt werden, so dass ein Lastverschiebepotential optimal bestimmt werden kann. Insbesondere kann ein Lastverschiebepotential derart bestimmt werden, dass Lastspitzen bzw. Stromspitzen in einem Stromnetz optimal kompensiert werden und gleichzeitig sichergestellt ist, dass der elektrische Verbraucher einen Wärmekreis bzw. einen Kältekreis mit Wärme bzw. Kälte gemäß Benutzeranforderungen versorgt.

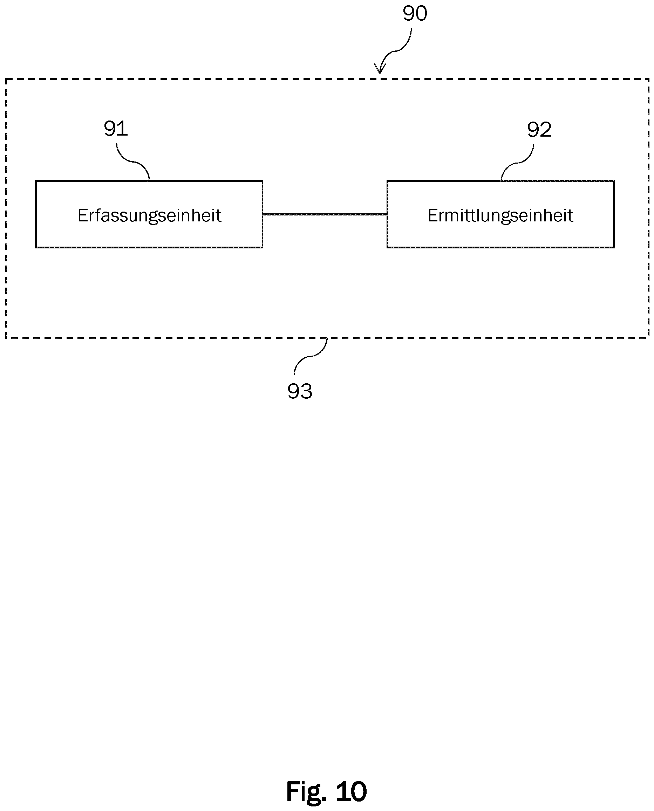

Fig. 10 zeigt schematisch ein System gemäß einer Ausführungsform der Erfindung. Das System 90 umfasst eine Erfassungseinheit 91 und eine Ermittlungseinheit 92. Die Erfassungseinheit ist dazu eingerichtet, einen elektrischen Energieverbrauch eines elektrischen Verbrauchers als Referenzenergieverbrauch des elektrischen Verbrauchers zu erfassen. Die Ermittlungseinheit ist dazu eingerichtet, ein Lastverschiebepotential des elektrischen Verbrauchers in Abhängigkeit des Referenzenergieverbrauchs des elektrischen Verbrauchers zu ermitteln. Insbesondere kann das System 90 dazu eingerichtet sein, ein in den Fig. 1 bis 6 gezeigtes Verfahren auszuführen. Dazu kann das System zusätzliche Einheiten umfassen. Insbesondere kann die Erfassungseinheit 91 zum Ausführen eines Erfassens gemäß einem der in den Fig. 1 bis 6 gezeigten Schritte eingerichtet sein. Die Ermittlungseinheit 92 kann beispielsweise zum Ausführen eines Ermittelns gemäß einem der in den Fig. 1 bis 6 gezeigten Schritte eingerichtet sein.

In manchen Ausführungsformen kann eine Signalverarbeitungseinheit 93 eines elektrischen Verbrauchers die Erfassungseinheit und/oder die Ermittlungseinheit umfassen. In manchen Ausführungsformen kann eine eigenständige Signalverarbeitungseinheit 93, insbesondere eine Signalverarbeitungseinheit 93, die eigenständig gegenüber dem elektrischen Verbraucher ist, die Erfassungseinheit und/oder die Ermittlungseinheit umfassen. Dies kann den Vorteil haben, dass bestehende Wärme- bzw. Kälteversorgungssysteme nachträglich auf einfache Art und Weise mit einer Erfassungseinheit und/oder einer Ermittlungseinheit nachgerüstet werden können, so dass ein Lastverschiebepotential ermittelt werden kann.

In manchen Ausführungsformen kann die Erfassungseinheit 91 zum Erfassen des elektrischen Energieverbrauchs einer Vielzahl von elektrischen Verbrauchern eingerichtet sein. In manchen Ausführungsformen kann die Ermittlungseinheit 92 zum Ermitteln des Lastverschiebepotentials einer Vielzahl von elektrischen Verbrauchern eingerichtet sein. Dies kann den Vorteil haben, dass ein Lastverschiebepotential einer Vielzahl elektrischer Verbraucher kostengünstig mittels einer Erfassungseinheit bzw. einer Ermittlungseinheit ermittelt werden kann.

In manchen Ausführungsformen kann das System eine Kommunikationseinheit umfassen (nicht in Fig. 10 gezeigt). Die Kommunikationseinheit kann beispielsweise dazu eingerichtet sein, ein oder mehrere Steuersignale, insbesondere ein Demand-Response-Signal an einen elektrischen Verbraucher zu senden und/oder Daten von einem oder mehreren elektrischen Verbrauchern zu empfangen. In manchen Ausführungsformen kann die Kommunikationseinheit dazu eingerichtet sein, Daten insbesondere eines elektrischen Verbrauchers von einem Cloudspeicher abzufragen. Zuvor können diese Daten beispielsweise durch einen elektrischen Verbraucher in dem Cloudspeicher gespeichert worden sein.

In manchen Ausführungsformen kann ein Erfassen der Erfassungseinheit ein Anfordern von Daten mittels der Kommunikationseinheit und/oder ein Auslesen/Verarbeiten von Daten, die die Kommunikationseinheit empfangen hat, umfassen.

In manchen Ausführungsformen kann die Kommunikationseinheit dazu eingerichtet sein, ein Angebot für eine Lastverschiebung in Abhängigkeit des ermittelten Lastverschiebepotentials zu versenden und/oder eine Bedarfsanfrage für eine Lastverschiebung zu empfangen. Auf Grundlage des Lastverschiebeangebots kann dann ein Netzbetreiber die angebotene Lastverschiebung, insbesondere in Teilen annehmen, sodass ein Steuersignal, insbesondere ein Demand-Response-Signal zu einem elektrischen Verbraucher in Abhängigkeit eines oder mehrerer ermittelter Lastverschiebepotentiale übermittelt wird. Bei einer Bedarfsanfrage kann einem elektrischen Verbraucher in Abhängigkeit dessen Lastverschiebepotentials ein Steuersignal, insbesondere ein Demand-Response-Signal, insbesondere mittels der Kommunikationseinheit übermittelt werden.

In manchen Ausführungsformen kann die Kommunikationseinheit dazu eingerichtet sein, ein Lastverschiebepotential eines elektrischen Verbrauchers insbesondere in Verbindung mit einem Verweis auf ein Stromnetz, in dem der elektrische Verbraucher angeordnet ist, in einer Datenbank, einen Cloudspeicher, einem digitalen Marktplatz etc. bereitzustellen.

In manchen Ausführungsformen kann die Erfassungseinheit 91 dazu eingerichtet sein, weitere Wärmeerzeugungseinheiten, wie beispielsweise eine Solaranlage, eine Holzfeuerungsanlage, einen Gaskessel, einen Ölkessel etc., zu detektieren und die Ermittlungseinheit kann dazu eingerichtet sein, das Lastverschiebepotential in Abhängigkeit der weiteren Wärmeerzeuger und in Abhängigkeit von Informationsdaten, die einen Betrieb der weiteren Wärmeerzeuger beeinflussen, zu ermitteln. Entsprechende Informationsdaten können beispielsweise Temperaturen, vorhergesagte Sonnenstunden, Effizienz des Wärmeerzeugers etc. sein.

## Patentansprüche

1. Verfahren zum Ermitteln eines Lastverschiebepotentials eines elektrischen Verbrauchers, wobei der elektrische Verbraucher zur Wärmeerzeugung und/oder Kälteerzeugung in einem oder mehreren Heiz- und/oder Kühlkreisen eingerichtet ist, umfassend die Schritte:
Erfassen (S11) eines elektrischen Energieverbrauchs des elektrischen Verbrauchers als Referenzenergieverbrauch des elektrischen Verbrauchers;
Ermitteln (S12) eines Lastverschiebepotentials des elektrischen Verbrauchers in Abhängigkeit des erfassten Referenzenergieverbrauchs des elektrischen Verbrauchers, **dadurch gekennzeichnet, dass**
das Lastverschiebepotential ein Maß dafür ist, inwieweit eine Anpassung einer elektrischen Last des elektrischen Verbrauchers hinsichtlich eines Zeitpunkts eines Energieverbrauchs des elektrischen Verbrauchers möglich ist.

2. Verfahren nach Anspruch 1 umfassend den zusätzlichen Schritt:
Ermitteln (S21) einer Beladezeitkonstante (τ₁) des elektrischen Verbrauchers in Abhängigkeit des erfassten Referenzenergieverbrauchs;
wobei das Ermitteln des Lastverschiebepotentials in Abhängigkeit der Beladezeitkonstante des elektrischen Verbrauchers erfolgt, wobei
das Ermitteln einer Beladezeitkonstante des elektrischen Verbrauchers in Abhängigkeit einer Dauer eines oder mehrerer Betriebsintervalle des elektrischen Verbrauchers erfolgt.

3. Verfahren nach Anspruch 1 oder 2 umfassend den zusätzlichen Schritt:
Ermitteln (S22) einer Entladezeitkonstante (τ₂) des elektrischen Verbrauchers in Abhängigkeit des erfassten Referenzenergieverbrauchs;
wobei das Ermitteln des Lastverschiebepotentials in Abhängigkeit der Entladezeitkonstante des elektrischen Verbrauchers erfolgt, wobei
das Ermitteln einer Entladezeitkonstante des elektrischen Verbrauchers in Abhängigkeit einer Länge eines oder mehrerer Zeiträume jeweils zwischen zwei aufeinander folgender Betriebsintervalle des elektrischen Verbrauchers erfolgt.

4. Verfahren nach einem der Ansprüche 1 bis 3 umfassend den zusätzlichen Schritt:
Ermitteln (S23) einer elektrischen Lastkapazität des elektrischen Verbrauchers in Abhängigkeit des erfassten Referenzenergieverbrauchs;
wobei das Ermitteln des Lastverschiebepotentials in Abhängigkeit der elektrischen Lastkapazität des elektrischen Verbrauchers erfolgt, wobei
das Ermitteln der elektrischen Lastkapazität des elektrischen Verbrauchers in Abhängigkeit einer elektrischen Leistung des elektrischen Verbrauchers während der Dauer eines oder mehrerer Betriebsintervalle des elektrischen Verbrauchers und/oder in Abhängigkeit eines Energieverbrauchs während der Dauer eines oder mehrerer Betriebsintervalle des elektrischen Verbrauchers erfolgt.

5. Verfahren nach einem der Anspruch 1 bis 4, wobei
das Erfassen (S11) des Referenzenergieverbrauchs den Schritt umfasst:
Erfassen einer Gesamtbetriebszeit des elektrischen Verbrauchers innerhalb einer ersten vorgegebenen Zeitdauer; und/oder
das Verfahren den zusätzlichen Schritt umfasst:
Erfassen (S31) einer aktuellen Betriebszeit des elektrischen Verbrauchers in einem ersten aktuellen Zeitintervall;
wobei das Ermitteln (S12) des Lastverschiebepotentials in Abhängigkeit der Gesamtbetriebszeit des elektrischen Verbrauchers und/oder zusätzlich in Abhängigkeit der aktuellen Betriebszeit des elektrischen Verbrauchers erfolgt.

6. Verfahren nach einem der Ansprüche 1 bis 5, wobei
das Erfassen (S11) des Referenzenergieverbrauchs den Schritt umfasst:
Erfassen eines Gesamtenergieverbrauchs des elektrischen Verbrauchers innerhalb einer zweiten vorgegebenen Zeitdauer; und/oder
das Verfahren den zusätzlichen Schritt umfasst:
Erfassen (S32) eines aktuellen Energieverbrauchs des elektrischen Verbrauchers in einem zweiten aktuellen Zeitintervall;
wobei das Ermitteln (S12) des Lastverschiebepotentials in Abhängigkeit des Gesamtenergieverbrauchs des elektrischen Verbrauchers und/oder zusätzlich in Abhängigkeit des aktuellen Energieverbrauchs des elektrischen Verbrauchers erfolgt.

7. Verfahren nach einem der Ansprüche 1 bis 6 umfassend die zusätzlichen Schritte:
Vorgeben (S41) einer Solltemperatur für einen Heiz- und/oder Kühlkreis des elektrischen Verbrauchers; und/oder
Erfassen (S42) einer Ist-Temperatur für einen Heiz- und/oder Kühlkreis der einen oder mehreren elektrischen Verbraucher;
Wobei das Ermitteln (S12) des Lastverschiebepotentials zusätzlich in Abhängigkeit der erfassten Solltemperatur und/oder zusätzlich in Abhängigkeit der erfassten Ist-Temperatur erfolgt.

8. Verfahren nach einem der Ansprüche 1 bis 7 umfassend die zusätzlichen Schritte:
Erfassen (S51) einer Außentemperatur als Referenzaußentemperatur in Verbindung mit dem Erfassen des Referenzenergieverbrauchs des elektrischen Verbrauchers; und/oder
Erfassen (S54) einer aktuellen Außentemperatur;
wobei das Ermitteln (S12) des Lastverschiebepotentials zusätzlich in Abhängigkeit der Referenzaußentemperatur und/oder zusätzlich in Abhängigkeit der aktuellen Außentemperatur erfolgt.

9. Verfahren nach einem der Ansprüche 1 bis 8, wobei
der elektrische Verbraucher zum Bereitstellen von Wärme und/oder Kälte in mehreren Kreisen eingerichtet ist, wobei ein Kreis ein Heiz- und/oder Kühlkreis ist;
das Erfassen (S11) des Referenzenergieverbrauchs des elektrischen Verbrauchers ein Erfassen der Ansteuerung der mehreren Kreise umfasst;
das Ermitteln (S12) des Lastverschiebepotentials ein Ermitteln des Lastverschiebepotentials für mindestens einen Kreis der mehreren Kreise umfasst; und/oder
das Verfahren zusätzlich den Schritt umfasst:
Ermitteln (S57) eines Überladungspotentials des elektrischen Verbrauchers und/oder der einen oder mehreren Kreise;
wobei das Ermitteln (S12) des Lastverschiebepotentials zusätzlich in Abhängigkeit des ermittelten Überladungspotentials erfolgt.

10. Verfahren nach einem der Ansprüche 1 bis 9 umfassend die zusätzlichen Schritte:
Bereitstellen des Lastverschiebepotentials, sodass der elektrische Verbraucher in Abhängigkeit des Lastverschiebepotentials des elektrischen Verbrauchers ansteuerbar ist, wobei eine Ansteuerung des elektrischen Verbrauchers insbesondere mittels eines Demand-Response Signals erfolgt; und gegebenenfalls Ausgeben einer Rückmeldung des elektrischen Verbrauchers, ob und/oder in wieweit eine Lastverschiebung des elektrischen Verbrauchers erfolgt, wenn ein Steuersignal, insbesondere ein Demand-Response Signal, an den elektrischen Verbraucher auf Grund des Lastverschiebepotentials übermittelt wird; und/oder
Erfassen (S52) einer Heizkreistemperatur, Kühlkreistemperatur, einer Soll-Temperatur und/oder Gebäudetemperatur als Referenztemperaturen in Verbindung mit dem Erfassen des Referenzenergieverbrauchs des elektrischen Verbrauchers; und/oder
Erfassen (S55) einer aktuellen Heizkreistemperatur, einer aktuellen Kühlkreistemperatur, einer aktuellen Soll-Temperatur und/oder einer aktuellen Gebäudetemperatur als aktuelle Temperaturen;
wobei das Ermitteln (S12) des Lastverschiebepotentials zusätzlich in Abhängigkeit der Referenztemperaturen und/oder zusätzlich in Abhängigkeit der aktuellen Temperaturen erfolgt; und/oder
Erfassen (S53) von Umweltfaktoren als Referenzumweltfaktoren in Verbindung mit dem Erfassen des Referenzenergieverbrauchs; und/oder
Erfassen (S56) von aktuellen Umweltfaktoren;
wobei das Ermitteln des Lastverschiebepotentials (S12) zusätzlich in Abhängigkeit der Erfassten Referenzumweltfaktoren und/oder der in Abhängigkeit der aktuellen Umweltfaktoren erfolgt.

11. Verfahren nach einem der Ansprüche 1 bis 10 umfassend die zusätzlichen Schritte:
Ermitteln (S61) eines Stromnetzes, das den elektrischen Verbraucher mit elektrischer Energie versorgt; und
Zuordnen (S62, S63) des elektrischen Verbrauchers zu einer Gruppe elektrischer Verbraucher in Abhängigkeit des ermittelten Stromnetzes und/oder des Lastverschiebepotentials.

12. System (90) zum Ermitteln eines Lastverschiebepotentials eines elektrischen Verbrauchers, wobei der elektrische Verbraucher zur Wärmeerzeugung und/oder Kälteerzeugung in einem oder mehreren Heiz- und/oder Kühlkreisen eingerichtet ist, umfassend:
eine Erfassungseinheit (91) zum Erfassen eines elektrischen Energieverbrauchs des elektrischen Verbrauchers als Referenzenergieverbrauch des elektrischen Verbrauchers; und
eine Ermittlungseinheit (92) zum Ermitteln eines Lastverschiebepotentials des elektrischen Verbrauchers in Abhängigkeit des Referenzenergieverbrauchs des elektrischen Verbrauchers, **dadurch gekennzeichnet, dass**
das Lastverschiebepotential ein Maß dafür ist, inwieweit eine Anpassung einer elektrischen Last des elektrischen Verbrauchers hinsichtlich eines Zeitpunkts eines Energieverbrauchs des elektrischen Verbrauchers möglich ist.

13. System (90) nach Anspruch 12, wobei
eine Signalverarbeitungseinheit (93) des elektrischen Verbrauchers die Erfassungseinheit und/oder die Ermittlungseinheit umfasst; oder
das System eine Signalverarbeitungseinheit (93) umfasst, die die Erfassungseinheit (91) und/oder die Ermittlungseinheit (92) umfasst; und/oder
das System eine Kommunikationseinheit umfasst, die dazu eingerichtet ist, ein Angebot für eine Lastverschiebung in Abhängigkeit des ermittelten Lastverschiebepotentials zu versenden und/oder eine Bedarfsanfrage für eine Lastverschiebung zu empfangen.

14. System (90) nach einem der Ansprüche 12 oder 13, wobei
die Erfassungseinheit (91) zum Erfassen des elektrischen Energieverbrauchs einer Vielzahl von elektrischen Verbrauchern eingerichtet ist und/oder
die Ermittlungseinheit (92) zum Ermitteln des Lastverschiebepotentials einer Vielzahl an elektrischen Verbrauchern eingerichtet ist.

15. Computerprogramm-Produkt, umfassend Befehle, die bei der Ausführung des Programms durch ein System nach einem der Ansprüchen 12-14 dieses veranlassen, die Schritte des Verfahrens nach einem der Ansprüche 1 bis 11 auszuführen.

## Claims

1. Method for determining a load shift potential of an electrical load, wherein the electrical load is set up for heat generation and/or cold generation in one or more heating and/or cooling circuits, comprising the steps:
detecting (S11) an electrical energy consumption of the electrical load as a reference energy consumption of the electrical load;
determining (S12) a load shift potential of the electrical load as a function of the detected reference energy consumption of the electrical load, **characterized in that**
the load shift potential is a measure of the extent to which an adaptation of an electrical load of the electrical load is possible with regard to a time of an energy consumption of the electrical load.

2. Method according to Claim 1, comprising the additional step:
determining (S21) a loading time constant (τ₁) of the electrical load as a function of the detected reference energy consumption;
wherein the load shift potential is determined as a function of the loading time constant of the electrical load, wherein
a loading time constant of the electrical load is determined as a function of a duration of one or more operating intervals of the electrical load.

3. Method according to Claim 1 or 2, comprising the additional step:
determining (S22) a discharging time constant (τ₂) of the electrical load as a function of the detected reference energy consumption;
wherein the load shift potential is determined as a function of the discharging time constant of the electrical load, wherein
a discharging time constant of the electrical load is determined as a function of a length of one or more time periods in each case between two successive operating intervals of the electrical load.

4. Method according to one of Claims 1 to 3, comprising the additional step:
determining (S23) an electrical load capacity of the electrical load as a function of the detected reference energy consumption;
wherein the load shift potential is determined as a function of the electrical load capacity of the electrical load, wherein
the electrical load capacity of the electrical load is determined as a function of an electrical power of the electrical load during the duration of one or more operating intervals of the electrical load and/or as a function of an energy consumption during the duration of one or more operating intervals of the electrical load.

5. Method according to one of Claims 1 to 4, wherein
the detection (S11) of the reference energy consumption comprises the step:
detecting a total operating time of the electrical load within a first predefined time period; and/or
the method comprises the additional step:
detecting (S31) a current operating time of the electrical load in a first current time interval;
wherein the load shift potential is determined (S12) as a function of the total operating time of the electrical load and/or additionally as a function of the current operating time of the electrical load.

6. Method according to one of Claims 1 to 5, wherein
the detection (S11) of the reference energy consumption comprises the step:
detecting a total energy consumption of the electrical load within a second predefined time period; and/or
the method comprises the additional step:
detecting (S32) a current energy consumption of the electrical load in a second current time interval;
wherein the load shift potential is determined (S12) as a function of the total energy consumption of the electrical load and/or additionally as a function of the current energy consumption of the electrical load.

7. Method according to one of Claims 1 to 6, comprising the additional steps:
predefining (S41) a setpoint temperature for a heating and/or cooling circuit of the electrical load; and/or
detecting (S42) an actual temperature for a heating and/or cooling circuit of the one or more electrical loads;
wherein the load shift potential is determined (S12) additionally as a function of the detected setpoint temperature and/or additionally as a function of the detected actual temperature.

8. Method according to one of Claims 1 to 7, comprising the additional steps:
detecting (S51) an outside temperature as a reference outside temperature in conjunction with the detection of the reference energy consumption of the electrical load; and/or
detecting (S54) a current outside temperature;
wherein the load shift potential is determined (S12) additionally as a function of the reference outside temperature and/or additionally as a function of the current outside temperature.

9. Method according to one of Claims 1 to 8, wherein
the electrical load is set up for providing heat and/or cold in a plurality of circuits, wherein one circuit is a heating and/or cooling circuit;
the detection (S11) of the reference energy consumption of the electrical load comprises a detection of the actuation of the plurality of circuits;
the determination (S12) of the load shift potential comprises a determination of the load shift potential for at least one circuit of the plurality of circuits; and/or
the method additionally comprises the step:
determination (S57) of an overcharge potential of the electrical load and/or of the one or more circuits;
wherein the load shift potential is determined (S12) additionally as a function of the determined overcharge potential.

10. Method according to one of Claims 1 to 9, comprising the additional steps:
provision of the load shift potential, with the result that the electrical load can be actuated as a function of the load shift potential of the electrical load, wherein the electrical load is actuated in particular by means of a demand-response signal; and optionally output of a feedback from the electrical load as to whether and/or to what extent a load shift of the electrical load takes place if a control signal, in particular a demand-response signal, is transmitted to the electrical load on the basis of the load shift potential; and/or
detection (S52) of a heating circuit temperature, cooling circuit temperature, a setpoint temperature and/or building temperature as reference temperatures in conjunction with the detection of the reference energy consumption of the electrical load; and/or
detection (S55) of a current heating circuit temperature, a current cooling circuit temperature, a current setpoint temperature and/or a current building temperature as current temperatures;
wherein the load shift potential is determined (S12) additionally as a function of the reference temperatures and/or additionally as a function of the current temperatures; and/or
detection (S53) of environmental factors as reference environmental factors in conjunction with the detection of the reference energy consumption; and/or
detection (S56) of current environmental factors;
wherein the load shift potential is determined (S12) additionally as a function of the detected reference environmental factors and/or as a function of the current environmental factors.

11. Method according to one of Claims 1 to 10, comprising the additional steps:
determination (S61) of an electrical grid which supplies the electrical load with electrical energy; and
assignment (S62, S63) of the electrical load to a group of electrical loads as a function of the determined electrical grid and/or the load shift potential.

12. System (90) for determining a load shift potential of an electrical load, wherein the electrical load is set up for heat generation and/or cold generation in one or more heating and/or cooling circuits, comprising:
a detection unit (91) for detecting an electrical energy consumption of the electrical load as a reference energy consumption of the electrical load; and
a determination unit (92) for determining a load shift potential of the electrical load as a function of the reference energy consumption of the electrical load, **characterized in that**
the load shift potential is a measure of the extent to which an adaptation of an electrical load of the electrical load is possible with regard to a time of an energy consumption of the electrical load.

13. System (90) according to Claim 12, wherein
a signal processing unit (93) of the electrical load comprises the detection unit and/or the determination unit; or
the system comprises a signal processing unit (93) which comprises the detection unit (91) and/or the determination unit (92); and/or
the system comprises a communication unit which is set up to send an offer for a load shift as a function of the determined load shift potential and/or to receive a demand request for a load shift.

14. System (90) according to either of Claims 12 and 13, wherein
the detection unit (91) is set up for detecting the electrical energy consumption of a multiplicity of electrical loads and/or
the determination unit (92) is set up for determining the load shift potential of a multiplicity of electrical loads.

15. Computer program product comprising instructions which, when the program is executed by a system according to one of Claims 1214, cause said system to carry out the steps of the method according to one of Claims 1 to 11.

## Revendications

1. Procédé de détermination d'un potentiel de décalage de charge d'un consommateur électrique, le consommateur électrique étant conçu pour produire de la chaleur et/ou du froid dans un ou plusieurs circuits de chauffage et/ou de refroidissement, comprenant les étapes suivantes :
détection (S11) d'une consommation d'énergie électrique du consommateur électrique en tant que consommation d'énergie de référence du consommateur électrique ;
détermination (S12) d'un potentiel de décalage de charge du consommateur électrique en fonction de la consommation d'énergie de référence détectée du consommateur électrique, **caractérisé en ce que**
le potentiel de décalage de charge est une mesure de la mesure dans laquelle une adaptation d'une charge électrique du consommateur électrique est possible en ce qui concerne un instant d'une consommation d'énergie du consommateur électrique.

2. Procédé selon la revendication 1, comprenant l'étape supplémentaire suivante :
détermination (S21) d'une constante de temps de charge (τ₁) du consommateur électrique en fonction de la consommation d'énergie de référence détectée ;
la détermination du potentiel de décalage de charge étant effectuée en fonction de la constante de temps de charge du consommateur électrique,
la détermination d'une constante de temps de charge du consommateur électrique étant effectuée en fonction d'une durée d'un ou de plusieurs intervalles de fonctionnement du consommateur électrique.

3. Procédé selon la revendication 1 ou 2, comprenant l'étape supplémentaire suivante :
détermination (S22) d'une constante de temps de décharge (τ₂) du consommateur électrique en fonction de la consommation d'énergie de référence détectée ;
la détermination du potentiel de décalage de charge étant effectuée en fonction de la constante de temps de décharge du consommateur électrique,
la détermination d'une constante de temps de décharge du consommateur électrique étant effectuée en fonction d'une longueur d'une ou de plusieurs périodes de temps respectivement entre deux intervalles de fonctionnement successifs du consommateur électrique.

4. Procédé selon l'une quelconque des revendications 1 à 3, comprenant l'étape supplémentaire suivante :
détermination (S23) d'une capacité de charge électrique du consommateur électrique en fonction de la consommation d'énergie de référence détectée ;
la détermination du potentiel de décalage de charge étant effectuée en fonction de la capacité de charge électrique du consommateur électrique,
la détermination de la capacité de charge électrique du consommateur électrique étant effectuée en fonction d'une puissance électrique du consommateur électrique pendant la durée d'un ou de plusieurs intervalles de fonctionnement du consommateur électrique et/ou en fonction d'une consommation d'énergie pendant la durée d'un ou de plusieurs intervalles de fonctionnement du consommateur électrique.

5. Procédé selon l'une quelconque des revendications 1 à 4,
la détection (S11) de la consommation d'énergie de référence comprenant l'étape suivante :
détection d'un temps de fonctionnement total du consommateur électrique dans une première durée prédéfinie ; et/ou
le procédé comprenant l'étape supplémentaire suivante :
détection (S31) d'un temps de fonctionnement actuel du consommateur électrique dans un premier intervalle de temps actuel ;
la détermination (S12) du potentiel de décalage de charge étant effectuée en fonction du temps de fonctionnement total du consommateur électrique et/ou en outre en fonction du temps de fonctionnement actuel du consommateur électrique.

6. Procédé selon l'une quelconque des revendications 1 à 5,
la détection (S11) de la consommation d'énergie de référence comprenant l'étape suivante :
détection d'une consommation d'énergie totale du consommateur électrique dans une deuxième durée prédéfinie ; et/ou
le procédé comprenant l'étape supplémentaire suivante :
détection (S32) d'une consommation d'énergie actuelle du consommateur électrique dans un deuxième intervalle de temps actuel ;
la détermination (S12) du potentiel de décalage de charge étant effectuée en fonction de la consommation d'énergie totale du consommateur électrique et/ou en outre en fonction de la consommation d'énergie actuelle du consommateur électrique.

7. Procédé selon l'une quelconque des revendications 1 à 6, comprenant les étapes supplémentaires suivantes :
prédétermination (S41) d'une température de consigne pour un circuit de chauffage et/ou de refroidissement du consommateur électrique ; et/ou
détection (S42) d'une température réelle pour un circuit de chauffage et/ou de refroidissement du ou des consommateurs électriques ;
la détermination (S12) du potentiel de décalage de charge étant effectuée en outre en fonction de la température de consigne détectée et/ou en outre en fonction de la température réelle détectée.

8. Procédé selon l'une quelconque des revendications 1 à 7, comprenant les étapes supplémentaires suivantes :
détection (S51) d'une température extérieure en tant que température extérieure de référence en liaison avec la détection de la consommation d'énergie de référence du consommateur électrique ; et/ou
détection (S54) d'une température extérieure actuelle ;
la détermination (S12) du potentiel de décalage de charge étant effectuée en outre en fonction de la température extérieure de référence et/ou en outre en fonction de la température extérieure actuelle.

9. Procédé selon l'une quelconque des revendications 1 à 8,
le consommateur électrique étant conçu pour fournir de la chaleur et/ou du froid dans plusieurs circuits, un circuit étant un circuit de chauffage et/ou de refroidissement ;
la détection (S11) de la consommation d'énergie de référence du consommateur électrique comprenant une détection de la commande des plusieurs circuits ;
la détermination (S12) du potentiel de décalage de charge comprenant une détermination du potentiel de décalage de charge pour au moins un circuit des plusieurs circuits ; et/ou le procédé comprenant en outre l'étape suivante :
détermination (S57) d'un potentiel de surcharge du consommateur électrique et/ou des un ou plusieurs circuits ;
la détermination (S12) du potentiel de décalage de charge étant effectuée en outre en fonction du potentiel de surcharge déterminé.

10. Procédé selon l'une quelconque des revendications 1 à 9, comprenant les étapes supplémentaires suivantes :
fourniture du potentiel de décalage de charge, de sorte que le consommateur électrique peut être commandé en fonction du potentiel de décalage de charge du consommateur électrique, une commande du consommateur électrique étant effectuée en particulier au moyen d'un signal demande-réponse ; et éventuellement émission d'un message de retour du consommateur électrique indiquant si et/ou dans quelle mesure un décalage de charge du consommateur électrique est effectué lorsqu'un signal de commande, en particulier un signal demande-réponse, est transmis au consommateur électrique sur la base du potentiel de décalage de charge ; et/ou
détection (S52) d'une température de circuit de chauffage, d'une température de circuit de refroidissement, d'une température de consigne et/ou d'une température de bâtiment en tant que températures de référence en liaison avec la détection de la consommation d'énergie de référence du consommateur électrique ; et/ou
détection (S55) d'une température de circuit de chauffage actuelle, d'une température de circuit de refroidissement actuelle, d'une température de consigne actuelle et/ou d'une température de bâtiment actuelle en tant que températures actuelles ;
la détermination (S12) du potentiel de décalage de charge étant effectuée en outre en fonction des températures de référence et/ou en outre en fonction des températures actuelles ; et/ou
détection (S53) de facteurs environnementaux en tant que facteurs environnementaux de référence en liaison avec la détection de la consommation d'énergie de référence ; et/ou
détection (S56) de facteurs environnementaux actuels ;
la détermination du potentiel de décalage de charge (S12) étant effectuée en outre en fonction des facteurs environnementaux de référence détectés et/ou en fonction des facteurs environnementaux actuels.

11. Procédé selon l'une quelconque des revendications 1 à 10, comprenant les étapes supplémentaires suivantes :
détermination (S61) d'un réseau électrique qui alimente le consommateur électrique en énergie électrique ; et
affectation (S62, S63) du consommateur électrique à un groupe de consommateurs électriques en fonction du réseau électrique déterminé et/ou du potentiel de décalage de charge.

12. Système (90) de détermination d'un potentiel de décalage de charge d'un consommateur électrique, le consommateur électrique étant conçu pour produire de la chaleur et/ou du froid dans un ou plusieurs circuits de chauffage et/ou de refroidissement, comprenant :
une unité de détection (91) pour détecter une consommation d'énergie électrique du consommateur électrique en tant que consommation d'énergie de référence du consommateur électrique ; et
une unité de détermination (92) pour déterminer un potentiel de décalage de charge du consommateur électrique en fonction de la consommation d'énergie de référence du consommateur électrique, **caractérisé en ce que**
le potentiel de décalage de charge est une mesure de la mesure dans laquelle une adaptation d'une charge électrique du consommateur électrique est possible en ce qui concerne un instant d'une consommation d'énergie du consommateur électrique.

13. Système (90) selon la revendication 12,
une unité de traitement de signal (93) du consommateur électrique comprenant l'unité de détection et/ou l'unité de détermination ; ou
le système comprenant une unité de traitement de signal (93) qui comprend l'unité de détection (91) et/ou l'unité de détermination (92) ; et/ou
le système comprenant une unité de communication qui est conçue pour envoyer une offre pour un décalage de charge en fonction du potentiel de décalage de charge déterminé et/ou pour recevoir une demande de demande pour un décalage de charge.

14. Système (90) selon l'une quelconque des revendications 12 ou 13,
l'unité de détection (91) étant conçue pour détecter la consommation d'énergie électrique d'une pluralité de consommateurs électriques et/ou
l'unité de détermination (92) étant conçue pour déterminer le potentiel de décalage de charge d'une pluralité de consommateurs électriques.

15. Produit de programme informatique comprenant des instructions qui, lorsque le programme est exécuté par un système selon l'une quelconque des revendications 12 à 14, amènent celui-ci à exécuter les étapes du procédé selon l'une quelconque des revendications 1 à 11.
